**Europäisches Patentamt**

**European Patent Office**

**Office européen des brevets**

(19)

(11) **EP 1 431 826 A2**

(12) **EUROPÄISCHE PATENTANMELDUNG**

(43) Veröffentlichungstag:
**23.06.2004  Patentblatt 2004/26**

(51) Int Cl.⁷: **G03F 7/20**, G02B 13/14,
G02B 13/24

(21) Anmeldenummer: 03027119.1

(22) Anmeldetag: **26.11.2003**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(30) Priorität: **09.12.2002  DE 10258718**

(71) Anmelder: **Carl Zeiss SMT AG
73447 Oberkochen (DE)**

(72) Erfinder:
• **Epple, Alexander
73431 Aalen (DE)**

• **Kaiser, Winfried
73431 Aalen (DE)**
• **Ulrich, Wilhelm
73434 Aalen (DE)**
• **Graeupner, Paul
73430 Aalen (DE)**
• **Garreis, Reiner
73431 Aalen (DE)**

(74) Vertreter: **Muschik, Thomas (DE)
Patentanwälte Ruff, Wilhelm,
Beier, Dauster & Partner,
Kronenstrasse 30
70174 Stuttgart (DE)**

(54) **Projektionsobjektiv, insbesondere für die Mikrolithographie, sowie Verfahren zur Abstimmung eines Projektionsobjektives**

(57)     Ein Verfahren zur Abstimmung eines Projektionsobjektivs (10) erlaubt es, das Projektionsobjektiv mit geringen Eingriffen in das System zwischen einer Immersionskonfiguration und einer Trockenkonfiguration abzustimmen und damit wahlweise als Immersionobjektiv oder als Trockenobjektiv zu verwenden. Das Projektionsobjektiv hat eine Vielzahl von optischen Elementen, die entlang einer optischen Achse (13) des Projektionsobjektivs angeordnet sind, wobei die optischen Elemente eine der Objektebene (11) folgende erste Gruppe (14) von optischen Elementen und ein der ersten Gruppe folgendes, der Bildebene nächstes letztes optisches Element (15) umfassen, das eine Austrittsfläche (16) des Projektionsobjektivs definiert, die in einem Arbeitsabstand zur Bildebene (12) angeordnet ist. Das letzte optische Element ist im Wesentlichen brechkraftfrei und hat keine oder nur eine geringe Durchbiegung. Das Verfahren umfasst eine Veränderung der Dicke des letzten optischen Elementes (15), eine Änderung des Brechungsindex des Raumes (17) zwischen der Austrittsfläche (16) und der Bildebene (12) durch Einführen oder Entfernen eines Immersionsmediums, und vorzugsweise eine axiale Verlagerung des letzten optischen Elementes zur Einstellung eines geeigneten Arbeitsabstandes.

Fig. 1

**Beschreibung**

Die Erfindung bezieht sich auf ein Projektionsobjektiv zur Abbildung eines in einer Objektebene des Projektionsobjektivs angeordneten Musters in eine Bildebene des Projektionsobjektivs sowie auf ein Verfahren zur Abstimmung eines solchen Projektionsobjektivs. Bevorzugtes Anwendungsgebiet sind Projektionsobjektive für die Verwendung in Mikrolithographie-Projektionsbelichtungsanlagen.

Photolithographische Projektionsobjektive werden seit mehreren Jahrzehnten zur Herstellung von Halbleiterbauelementen und anderen feinstrukturierten Bauteilen verwendet. Sie dienen dazu, Muster von Photomasken oder Strichplatten, die nachfolgend auch als Masken oder Retikel bezeichnet werden, auf einen mit einer lichtempfindlichen Schicht beschichteten Gegenstand, beispielsweise auf einen mit Photolack beschichteten Halbleiterwafer, mit höchster Auflösung in verkleinerndem Maßstab zu projizieren.

Zur Erzeugung immer feinerer Strukturen in der Größenordnung von 100nm oder darunter werden mehrere Entwicklungsrichtungen verfolgt. Es wird einerseits versucht, die bildseitige numerische Apertur (NA) der Projektionsobjektive über die derzeit üblichen Werte hinaus in den Bereich von NA=0,8 oder darüber zu vergrößern. Außerdem werden immer kürzere Wellenlängen verwendet, vorzugsweise Ultraviolettlicht mit Wellenlängen von weniger als 260nm, beispielsweise 248 nm, 193 nm, 157 nm oder darunter. Manchmal wird auch versucht, durch Verwendung phasenschiebender Masken und/oder schräger Beleuchtung eine Verbesserung der Auflösung und/oder Schärfentiefe zu erzielen.

Herkömmlich werden fast ausschließlich Projektionsobjektive verwendet, bei denen im Bildraum zwischen der Austrittsfläche des letzten optischen Elementes und der Bildebene ein endlicher Arbeitsabstand besteht, der im Betrieb mit Luft oder einem anderen geeigneten Gas gefüllt ist. Solche Systeme werden als "Trockensysteme" oder "Trockenobjektive" bezeichnet. Der Bildraum ist in der Regel mit Helium, Stickstoff oder einem anderen Gas oder Gasgemisch mit Brechungsindex $n \cong 1$ gefüllt.

Es gibt schon Ansätze, die erzielbare Auflösung dadurch zu verbessern, dass in den Zwischenraum zwischen der Austrittsfläche des letzten optischen Elementes und dem Substrat ein Immersionsmedium mit hohem Brechungsindex eingebracht wird. Diese Technik wird als Immersions-Lithographie bezeichnet. Ein frühes Beispiel hierzu ist in US 4,346,164 gezeigt. Die an diese Technik angepassten Projektionsobjektive bezeichnet man als "Immersionssysteme" oder "Immersionsobjektive". Allein durch Einführung der Immersion ändert sich die numerische Apertur $NA = n \cdot \sin \Theta$ und damit die Auflösung

$$CD = k_1 \cdot \frac{\lambda}{NA}$$

nicht. Hier ist $\Theta$ der paraxiale Randstrahlwinkel, $\lambda$ die Wellenlänge und CD die Größe der auflösbaren kritischen Dimension. Die empirische Konstante $k_1$ ist prozessabhängig. Unter Zuhilfenahme von Immersionsmedien ist es möglich, numerische Aperturen von NA > 1, insbesondere bis zu NA = 1,3 oder 1,4 zu erreichen. Typische Arbeitsabstände liegen bei der Immersions-Lithographie deutlich unterhalb der bei Luftsystemen üblichen Werte.

Die herkömmlich angestrebten Vorteile der Immersions-Lithographie liegen im wesentlichen im Potential, die numerische Apertur auf Werte NA > 1 zu erhöhen, und damit in der verbesserten Auflösung. Einige für die Immersions-Lithographie geeignete, refraktive Projektionsobjektive mit bildseitigen numerischen Aperturen NA > 1 sind in den Patentanmeldungen DE 102 10 899 und PCT/EP 02/04846 der Anmelderin offenbart.

Ein anderer für den Belichtungsprozess wichtiger Parameter ist die erzielbare Schärfentiefe (depth of focus, DOF, auch Tiefenschärfe genannt). Diese reduziert sich bei Luftsystemen proportional zu $1/NA^2$, so dass es mit hochaperturigen Projektionsobjektiven schwierig werden kann, praxistaugliche Werte für die Schärfentiefe zu erhalten. Dadurch werden die Anforderungen an eine lagerichtige Anordnung der zu belichtenden Substrate und an deren Oberflächenqualität deutlich erhöht.

Der Erfindung liegt die Aufgabe zugrunde, ein Projektionsobjektiv und ein geeignetes Verfahren zur Abstimmung von Projektionsobjektiven zu schaffen, die es dem Anwender erlauben, Belichtungsprozesse unter unterschiedlichen Prozessbedingungen optimal durchzuführen.

Zur Lösung dieser Aufgabe stellt die Erfindung ein Projektionsobjektiv mit den Merkmalen von Anspruch 1 oder 17 sowie ein Verfahren zur Abstimmung eines Projektionsobjektives mit den Merkmalen des Anspruchs 20 bereit. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Erfindungsgemäße Projektionsobjektive zur Abbildung eines in eine Objektebene des Projektionsobjektivs angeordneten Musters in eine Bildebene des Projektionsobjektivs haben eine Vielzahl von optischen Elementen, die in der Regel entlang einer optischen Achse des Projektionsobjektivs angeordnet sind. Die optischen Elemente umfassen eine der Objektebene folgende erste Gruppe von optischen Elementen und ein der ersten Gruppe folgendes, der Bildebene nächstes letztes optisches Element, das eine Austrittsfläche des Projektionsobjektivs definiert, die in einem Arbeitsabstand zur Bildebene angeordnet ist. Dabei ist das letzte optische Element im Wesentlichen brechkraftfrei und hat keine oder nur eine geringe Durchbiegung. Das Projektionsobjektiv ist bezüglich Aberrationen darauf abgestimmt, dass der Arbeitsabstand mit einem Immersionsmedium mit einem Brechungsindex deutlich größer als 1 ausgefüllt ist.

Optische Elemente mit schwacher Brechkraft im Sinne der Anmeldung sind entweder im wesentlichen brechkraftfrei, wie beispielsweise eine planparallele Platte, oder haben nur sehr geringe Brechkraft. Es können Elemente mit mindestens einer leicht gekrümmten Fläche sein, bei denen der Radius der gekrümmten optischen Fläche um Größenordnungen größer sind als der Durchmesser des optischen Elementes. Die Austrittsseite ist idealerweise weitgehend eben, so dass maximal eine schwache Durchbiegung resultiert. Bei richtiger Justage kann dann eine im Wesentlichen gleichmäßige Dicke der Immersionsschicht gewährleistet werden. Bei optischen Elementen mit diesen Eigenschaften ist eine axiale Verlagerung parallel zur optischen Achse ohne wesentliche Änderungen der optischen Eigenschaften des Systems möglich.

Eine Besonderheit eines solchen Immersionsobjektivs ist es, dass es durch geringfügige Eingriffe in die mechanisch/optische Konfiguration zwischen einer "Immersionskonfiguration" und einer "Trockenkonfiguration" abgestimmt werden kann. Eine "Trockenkonfiguration" ist eine mechanisch/optische Konfiguration des Projektionsobjektives, bei dem dieses als "Trockensystem" verwendet werden kann. In der Trockenkonfiguration sind die optischen Eigenschaften des Projektionsobjektives so optimiert, dass bei einem gasgefüllten bildseitigen Arbeitsabstand am belichteten Substrat optimale Abbildungsverhältnisse vorliegen. Im Gegensatz dazu zeichnet sich die "Immersionskonfiguration" dadurch aus, dass bei dieser mechanisch/optischen Konfiguration des gleichen Projektionsobjektives eine optimale Abbildung am Substrat dann gegeben ist, wenn sich zwischen der Austrittsfläche des Projektionsobjektivs und dem Substrat ein Immersionsmedium befindet, dessen Brechungsindex deutlich größer als derjenige von Luft oder einem anderen üblicherweise verwendeten Gas.

Die optischen Elemente der ersten optischen Gruppe sind insgesamt so ausgelegt, dass sie eine sphärische Unterkorrektur der hindurchtretenden Wellenfronten bewirken. Die Dicke des letzten optischen Elementes, die Brechzahl (oder eine Brechzahlkombination) des Materials des letzten optischen Elementes und die Brechzahl des verwendeten Immersionsmediums sind dabei so aneinander angepasst, dass in der Bildebene ein hinreichend guter Korrekturzustand der Abbildung, insbesondere bezüglich sphärischer Aberration, vorliegt.

Vorzugsweise besteht zwischen der ersten Gruppe und dem letzten optischen Element ein großer Abstand, der eine substantielle axiale Verlagerung des letzten optischen Elementes, insbesondere ohne Verschiebung von benachbarten optischen Elementen, ermöglicht. Die Möglichkeit, das letzte optische Element relativ zur Bildebene bei der Abstimmung axial zu verlagern, erlaubt es, den Arbeitsabstand zwischen Austrittsfläche und Substratoberfläche geeignet einzustellen. Vorzugsweise ist das Projektionsobjektiv so ausgelegt, dass der Arbeitsabstand in der Immersionskonfiguration kleiner ist als in der Trockenkonfiguration. Typische Arbeitsabstände für Trockensysteme können im Bereich mehrerer Millimeter liegen, beispielsweise zwischen ca. 5 und ca. 20 mm, insbesondere zwischen ca. 6 und ca. 12 mm. Typische Arbeitsabstände in der Immersionskonfiguration können dagegen deutlich geringer sein, sie können im Bereich von wenigen Millimetern, beispielsweise 1 bis 2 mm, oder darunter liegen.

Mit Hilfe eines durch die Erfindung geschaffenen Verfahrens zur Abstimmung eines Projektionsobjektives kann dieses Immersionsobjektiv durch wenige Maßnahmen in ein Trockenobjektiv überführt werden. Das Verfahren umfasst eine Veränderung der Dicke des letzten optischen Elementes und eine Änderung des Brechungsindex des Raumes zwischen der Austrittsfläche und der Bildebene. Vorzugsweise ist zusätzlich eine axiale Verlagerung des letzten optischen Elementes zur Einstellung eines geeigneten Arbeitsabstandes vorgesehen.

Beim Übergang von der Immersionskonfiguration zur Trockenkonfiguration wird beispielsweise der Brechungsindex im bildseitigen Arbeitsbereich von relativ hohen Werten des Immersionsmediums (typischerweise n >1,3 ) auf kleinere Werte um ca. n = 1 bis 1,1 für ein geeignetes Gas verringert. Die Dicke des letzten optischen Elementes wird verändert, im allgemeinen vergrößert, und das optische Element wird, falls erforderlich oder zweckmäßig, in Richtung der ersten Gruppe verlagert, um einen größeren Arbeitsabstand einzustellen.

Bei einer Rekonfiguration des Systems von einem Trockensystem zu einem Immersionssystem verlaufen die Änderungen in die umgekehrte Richtung. Dabei wird die Dicke des letzten optischen Elementes normalerweise reduziert, und gegebenenfalls das optische Element in Richtung Bildebene zur Einstellung eines kleineren Arbeitsabstandes verlagert. Durch Einführung eines Immersionsmediums in den (kleiner gewordenen) Abstandsbereich wird der Brechungsindex dieses Bereiches vergrößert.

Der physikalische Hintergrund der beschriebenen Maßnahmen kann wie folgt verstanden werden. Ein letztes optisches Element mit den beschriebenen Eigenschaften, beispielsweise eine im Wesentlichen planparallele Platte, bewirkt für sich allein eine sphärische Überkorrektur, deren Ausmaß abnimmt, je größer der Brechungsindex des Materials ist. Die erzeugbare Überkorrektur skaliert mit der Dicke und nimmt mit abnehmender Dicke ab. Diese Effekte sind an sich bekannt. Beispielsweise ist im Patent US 5,973,863 ein Trockenobjektiv beschrieben, das als letztes optisches Element eine auswechselbare Platte haben kann. Durch Austauch von Platten unterschiedlicher Krümmungen werden sphärische Aberration und/oder Bildfeldkrümmung eingestellt.

Der Öffnungsfehler SPH einer Planplatte der Dicke d in Luft kann z.B. wie folgt als Längsaberration SPH für den Pupillenrand berechnet werden:

$$SPH = d \cdot \left( \frac{1}{n} - \sqrt{\frac{1 - NA^2}{n^2 - NA^2}} \right)$$

Ersetzt man beispielsweise eine Planplatte durch ein Medium mit anderer Brechzahl, so ändert sich auch die sphärische Aberration, die diese in das System einführt. Theoretisch kann jedoch durch eine Dickenskalierung des neuen optischen Elements die sphärische Aberration nur für genau eine Pupillenhöhe (d.h. in obiger Formel einen Wert von NA < NA des Objektivs) auf den Wert vor dem Tausch angepaßt werden, so dass Zonenfehler in der sphärischen Aberration verbleiben. Diese Zonenfehler sind umso größer, je dicker der auszutauschende Bereich ist, bzw. je stärker der Brechungsindex des Immersionsmediums von der Brechzahl des letzten optischen Elementes abweicht.

Kleine Arbeitsabstände in der Immersionskonfiguration, kleine numerischen Aperturen der Projektionsobjektive und/oder eine gute Übereinstimmung der Brechzahlen des an die Austrittsfläche angrenzenden Materials und Immersionsmedium begünstigen die Minimierung von Zonenfehlern. Abhängig von den Spezifikationen des Systems kann somit eine solche Grundkompensation ausreichen, um ein Trockenobjektiv auf ein Immersionsobjetiv (oder umgekehrt) abzustimmen.

Es ist insbesondere auch möglich, bei der Modifikation des Systems von Immersions- zu Trockenkonfiguration das Immersionsmedium durch ein optisch transparentes Material mit guter Brechzahlübereinstimmung zu ersetzen (Indexmatching). Beispielsweise kann durch Verwendung von Kalziumfluorid, Lithiumfluorid oder dergleichen an Stelle von Quarzglas für die an die Austrittsfläche angrenzende optische Komponente ein verbessertes Indexmatching erreicht werden. Hierdurch kann die Entstehung von Restaberrationen wesentlich verringert werden. Das an die Austrittsfläche angrenzende optische Material des letzten optischen Elements sollte somit einen Brechungsindex $n_E$ haben, der in der Nähe des Brechungsindex $n_I$ des Immersionsmediums liegt, wobei vorzugsweise ein Verhältnis $n_I / n_E$ mehr als 0,8, insbesondere mehr als 0,9 beträgt. Beispielsweise kann bei einem aus zwei Platten bestehenden letzten optischen Element die letzte Platte (mit Austrittsfläche) aus Kalziumfluorid oder Lithiumfluorid bestehen. Diese Platte kann im Fall der Trockenkonfiguration eingebaut und im Falle der Immersionskonfiguration entfernt sein. Ihre optische Wirkung wird dann durch das Immersionsfluid weitgehend ersetzt.

Falle es erforderlich oder gewünscht ist, die verbleibenden Zonenfehler zu korrigieren, kann das Projektionsobjektiv zusätzlich noch weiter abgestimmt werden, beispielsweise indem gezielt die Lufträume zwischen Linsen variiert werden. Dies wird weiter unten noch näher erläutert.

Es hat sich gezeigt, dass sich durch Verwendung hochbrechender Immersionsfluide eine signifikante Vergrößerung der Schärfentiefe erreichen lässt. Dieser Effekt ist unabhängig von der numerischen Apertur und kann insbesondere bereits bei Aperturen von weniger als 1,0 genutzt werden. Es kann gezeigt werden, dass die Schärfentiefe wie folgt berechnet werden kann:

$$DOF = k_2 \cdot \lambda \, / \, [2 \cdot n(1 - \sqrt{1 - (NA/n)^2}]$$

Diese Beziehung geht für kleine Werte von NA in die bekannte paraxiale Beziehung

$$DOF = k_2 \cdot n \, \frac{\lambda}{NA}$$

über. Die Konstante $k_2$ ist prozessabhängig. Daraus ergibt sich beispielsweise, dass sich bei einem Projektionsobjektiv mit NA=0,95 und einem Brechungsindex n = 1,45 des Immersionsmediums gegenüber einem Trockenobjektiv (n = 1,0) ein Gewinn an Tiefenschärfe von nahezu einem Faktor 2 erreichen lässt. Hierdurch können die Anforderungen an die Genauigkeit der Positionierung der zu belichtenden Substrate sowie an deren Oberflächenverlauf deutlich reduziert werden. Außerdem können auch bei nicht-idealer Fokussierung und/oder bei bereits strukturierten Oberflächen feinste Strukturen mit ausreichender Schärfe erzeugt werden.

Als Immersionsmedien können beispielsweise geeignete Flüssigkeiten verwendet werden. Typische Brechungsindizes geeigneter Immersionsfluide können bei n ≅ 1,3 oder höher liegen. In dem Artikel "Immersion Lithography at 157nm" von M. Switkes und M. Rothschild, J. Vac.

Sci. Technol. B 19 (6), Nov./Dec. 2001, Seiten 1ff werden Immersionsflüssigkeiten auf Basis von Perfluorpolyethern (PFPE) vorgestellt, welche für 157 nm Arbeitswellenlänge ausreichend transparent und mit einigen derzeit in der Mikrolithographie verwendeten Photoresist-Materialien kompatibel sind. Eine getestete Immersionsflüssigkeit hat bei 157 nm einen Brechungsindex n = 1,37. Bei 193 nm Wellelänge kann z.B. deionisiertes Wasser mit Brechungsindex n = 1,45 verwendet werden.

Das letzte optische Element kann axial verschiebbar gelagert sein. Durch geeignete Fassung des letzten optischen Elementes ist beispielsweise eine z-Manipulation, d.h. eine Parallelverschiebung des gesamten optischen Elementes parallel zur optischen Achse möglich. Geeignete Fassungen zur Durchführung derartiger Axialbewegungen sind beispielsweise aus dem Patent US 4,961,001 bekannt. Zur Verlagerung kann das Element auch ausgebaut und nach Einfügen oder Wegnahme eines Abstandhalters wieder eingebaut werden, um es an verschiedenen Axialpositionen anzubringen.

Es ist möglich, dass das letzte optische Element eine Dicke hat, die ohne Materialabtrag oder Materialauftrag veränderbar ist. Beispielsweise kann das letzte optische Element aus zwei oder mehr lösbar bzw. trennbar miteinander verbundenen Komponenten bestehen, die mit Abstand zueinander angeordnet, aneinander angesprengt oder auf andere Weise optisch neutral miteinander verbunden sind. Hat beispielsweise das letzte optische Element eine (dicke) innere und eine (dünne) äußere Platte, kann durch Wegnahme bzw. Einfügen der dünnen Platte die Dicke des letzten optischen Elementes im wesentlichen um die Dicke der dünnen Platte vermindert bzw. vergrößert und damit die Dicke des Elementes um diesen Betrag geändert werden. Das letzte optische Element kann somit einteilig oder mehrteilig aufgebaut sein. Es kann generell auch als zweite Gruppe bezeichet werden.

Es ist auch möglich, die Dicke durch materialabtragende oder materialauftragende Bearbeitung des letzten optischen Elementes zu verändern. Hierzu wird normalerweise das letzte optische Element ausgebaut und nach Anpassung der Dicke wieder eingebaut.

Hat das letzte optische Element eine oder mehrere im Wesentlichen planparallele Platten aus transparentem Material, so hat dies den Vorteil, dass dieses Element zur Verstellung des Arbeitsabstandes frei entlang der optischen Achse verschoben oder verlagert werden kann, ohne dass die Axialposition einen Einfluss auf die Aberrationen des Objektivs hat.

Um eine axiale Verschiebung oder Verlagerung des letzten optischen Elementes zu erleichtern, beträgt bei einigen Ausführungsformen erfindungsgemäßer Projektionsobjektive ein freier, d.h. materialfreier Arbeitsabstand vor dem letzten Element (d.h. innerhalb des Projektionsobjektivs) mehr als ca. 0,5% -1% der Baulänge des Projektionsobjektivs. Hierdurch werden große Verschiebungswege möglich, die typischerweise in der Größenordnung mehrerer Millimeter bis weniger Zentimeter liegen können. Günstigerweise hat das letzte optische Element beidseitig relativ große axiale Spielräume. Beispielsweise kann eine Summe aus dem freien Abstand vor dem letzten optischen Element und dem Abstand zwischen Austrittsfläche und Bildebene größer als ca. 0,5% - 1% der Baulänge des Projektionsobjektivs sein.

Wird der Arbeitsabstand eines Trockenobjektivs verkleinert und mit einem Immersionsmedium, z.B. einer Flüssigkeit, gefüllt, so werden diese Designänderungen in der Regel zu starken Aberrationen führen, die ihren Ursprung vor allem in der endlichen Dicke der Immersionsschicht und der normalerweise relativ hohen bildseitigen numerischen Apertur haben. Ähnliches gilt bei Vergrößerung des Arbeitsabstandes und Entfernung des Immersionsmediums beim Übergang vom Immersions- zum Trockenobjektiv. Insbesondere bei bildseitig telezentrischen Objektiven dominiert hier die sphärische Aberration. Bei manchen erfindungsgemäßen Projektionsobjektiven lassen sich diese Aberrationen durch eine gezielte Dickenänderung des letzten, im Wesentlichen brechkraftlosen Elementes weitgehend kompensieren.

Es ist möglich, dass nicht kompensierbare Restfehler verbleiben, insbesondere in der Feldzone (Zonenfehler). Um diese Restfehler zu verringern ist es bei manchen Ausführungsformen möglich, die optischen Eigenschaften der ersten Gruppe so gezielt zu verändern, dass diese Restfehler weitgehend beseitigbar sind.

Bei manchen Ausführungsformen ist es möglich, durch geeignete Verlagerung mindestens eines verlagerbaren optischen Elementes der ersten Gruppe weitgehende oder vollständige Kompensation zu erreichen (Abstimmung). Maßgebliche Aberration ist die sphärische Aberration. Es gibt Ausführungsformen, bei denen das (mindestens eine) verlagerbare optische Element entlang der optischen Achse verlagerbar ist. Eine einmalige Verlagerung bei der Abstimmung kann ausreichen. Dies kann z.B. durch Einbau oder Ausbau von angrenzenden Abstandhaltern erreicht werden. Auch eine Abstimmung im Betrieb wäre möglich. Hierzu kann das optische Element in einer geeigneten Fassung mit der Möglichkeit einer steuerbaren z-Manipulation gefasst und damit beweglich sein. Es hat sich als vorteilhaft herausgestellt, wenn mehrere verlagerbare und/oder bewegliche optische Elemente vorgesehen sind, beispielsweise bis zu 5, 6, 7, 8, 9, 10 oder mehr solcher optische Elemente. Dadurch können die für die Beseitigung der Gesamtaberrationen erforderlichen Verlagerungen und/oder Bewegungen der Elemente auf viele Elemente verteilt werden, so dass an jedem einzelnen dieser Elemente nur geringfügige Verlagerungen erforderlich sind. Dies erleichtert die mechanische Konstruktion und gestattet mehr Freiheitsgrade bei der Manipulation.

Alternativ oder zusätzlich zu axialen Verlagerungen können auch Kippungen oder Dezentrierungen von einem oder mehreren beweglichen Elementen vorgesehen sein.

Die bei manchen Projektionsobjektiven vorgesehene Möglichkeit der Abstimmung zwischen Immersionskonfiguration und Trockenkonfiguration ist im Design mancher Ausführungsformen daran zu erkennen, dass ein freier Abstand vor einem verlagerbaren und/oder bewegichen Element und/oder hinter dem verlagerbaren und/oder beweglichen Element so groß bemessen ist, dass durch Verlagerung des optischen Elementes mindestens ein ausreichender Anteil von Aberrationen korrigierbar ist, die durch Einbringung eines Immersionsmediums im bildseitigen Arbeitsabstandsbereich entstehen.

Alternativ oder zusätzlich kann dem Projektionsobjektiv mindestens ein auswechselbares optisches Korrekturelement zugeordnet sein, das vorzugsweise mindestens eine asphärsche Fläche aufweist. Es kann sich z.B. um einen Satz von zwei oder mehr asphärisierten Korrekturplatten handeln, deren optische Wirkung jeweils so ausgelegt ist, das Restaberrationen beim Übergang von einer Trockenkonfiguration zu einer Immersionskonfiguration (oder umgekehrt) korrigiert werden. Korrekturelemente können in einem Wechselhalter, z.B. einem Revolver gehaltert sein und werden normalerweise an geeigneter Stelle innerhalb der ersten Gruppe, z.B. in der Nähe einer Pupillenebene oder einer Feldebene des Projektionsobjektives eingebracht.

Alternativ oder zusätzlich ist es auch möglich, eine bereits vorhandene optische Fläche, z.B. eine Eintritts- oder Austrittsfläche einer Linse, als Korrekturfläche zu gestalten, beispielsweise indem eine sphärische Fläache zu einer asphärischen Fläche bearbeitet wird.

Bei manchen Ausführungsformen ist an mindestens einem optischen Element mit mindestens einer gekrümmten optischen Fläche die Krümmung dieser optischen Fläche permanent oder reversibel veränderbar. Dadurch kann bei der Überführung zwischen einer Trockenkonfiguration und einer Immersionskonfiguration insbesondere auch mindestens ein Linsenradius variiert werden. Beispielsweise kann die veränderbare gekrümmte optische Fläche durch ein adaptiven Spiegel oder eine verspannbare Linse gebildet sein. Die Änderung mindestens eines Radius einer optischen Fläche kann zur Korrektur der Petzvalbedingung nützlich sein. Dies kann beispielsweise bei Trockenobjektiven nützlich sein, bei denen die Austrittsfläche nicht plan ist. Eine Veränderung des Radius ist in Bezug auf die Anpassung der optischen Eigenschaften dann besonders wirksam, wenn es der Radius einer der letzten (bildnächsten) Radien des Projektionsobjektivs ist und nicht an das Immersionsmedium angrenzt.

Viele Ausführungsformen erfindungsgemäß Projektionsobjektive sind darauf optimiert, bei günstiger Konstruktion dem Endnutzer die Möglichkeit einer Prozessführung mit großer Schärfentiefe zu geben. Daher können diese Projektionsobjektive so aufgebaut sein, dass bei Verwendung eines Immersionsmediums zwischen Austrittsfläche und Bildebene eine bildseitige numerische Apertur $NA < 1$ vorliegt, wobei diese vorzugsweise zwischen ca. 0,7 und 1, insbesondere zwischen 0,8 und 1 liegt. Bildseitige numerische Aperturen in der Nähe des Wertes 1 haben den Vorteil, dass in diesem hochaperturigen Bereich die Schärfentiefe mit wachsender Apertur überproportional zunimmt.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können.

Ausführungsbeispiele der Erfindung sind in den Zeichnungen dargestellt und werden im folgenden näher erläutert.

Fig. 1    ist eine schematische Darstellung eines refraktiven Projektionsobjektivs in Immersionskonfiguration mit Diagrammen zum Korrektionszustand (Queraberrationen des Achspunkts) ;

Fig. 2    ist eine schematische Darstellung des Projektionsobjektivs nach Entfernung des Immersionsmediums mit entsprechenden Diagrammen zum Korrektionszustand;

Fig. 3    ist eine schematische Darstellung des in Fig. 1 gezeigten Projektionsobjektives nach einer Vergrößerung der Dicke des letzten optischen Elementes mit entsprechenden Darstellungen des Korrektionszustandes;

Fig. 4    ist eine schematische Darstellung des in Fig. 1 gezeigten Projektionsobjektives beim Übergang zur Trockenkonfiguration mit vergrößertem Arbeitsabstand und Verschiebung mindestens einer waferfernen Linse sowie entsprechender Diagramme zum Korrektionszustand;

Fig. 5    zeigt einen Linsenschnitt durch eine Ausführungsform eines refraktiven Projektionsobjektivs in Immersionskonfiguration;

Fig. 6    zeigt einen vergrößerten Ausschnitt der bildnahen Linsen des Projektionsobjektivs aus Figur. 5;

Fig. 7    zeigt eine vergrößerte Darstellung gemäß Figur 6 des gleichen Projektionsobjektivs nach Abstimmung zur Trockenkonfiguration;

Fig. 8    zeigt eine Ausführungsform eines katadioptrischen Projektionsobjektivs mit geometrischem Strahlteiler in einer Immersionskonfiguration;

Fig. 9    zeigt einen vergrößerten Ausschnitt der bildnahen Linsen des in Figur 8 gezeigte Projektionsobjektivs und

Fig. 10   zeigt den in Figur 9 gezeigten Ausschnitt für eine Trockenkonfiguration des in Figur 8 gezeigten Projektionsobjektivs.

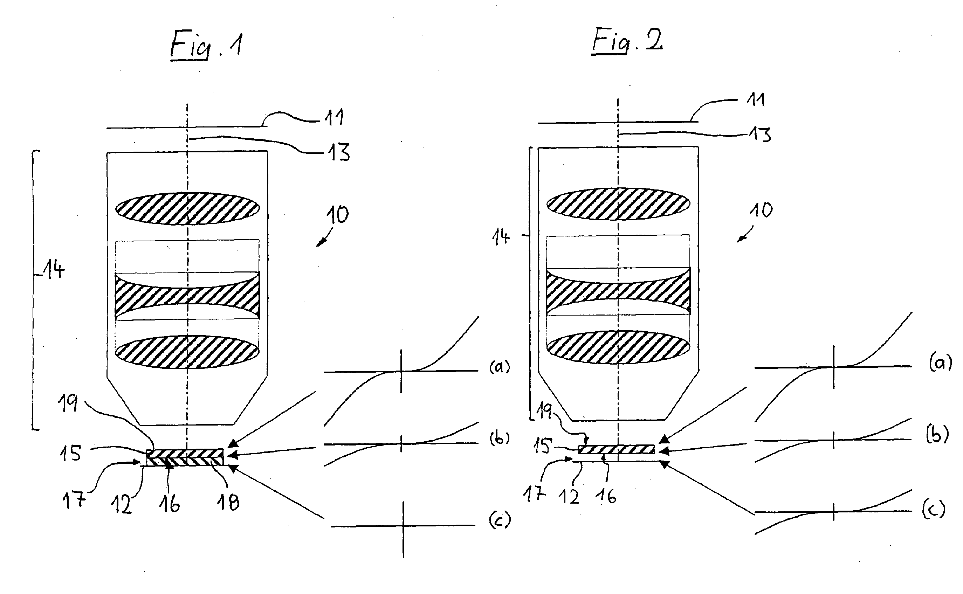

In Figur 1 ist schematisch ein refraktives Projektionsobjektiv 10 für die mikrolithografische Herstellung von Halbleiterbauelementen und anderen feinstrukturierten Bauteilen gezeigt. Das mit Ultraviolettlicht aus dem tiefen UV-Bereich (DUV) arbeitende Reduktionsobjektiv dient dazu, Muster von Fotomasken (Retikeln), die in der Objektebene 11 des Projektionsobjektivs angeordnet werden, in verkleinerndem Maßstab auf einen mit Fotolack beschichteten Halbleiterwafer zu projizieren, der in der Bildebene 12 des Projektionsobjektivs anzuordnen ist. Das Projektionsobjektiv hat eine Vielzahl optischer Elemente in Form von Linsen aus synthetischem Quarzglas, die entlang der optischen Achse 13 des Systems angeordnet sind. Die optischen Elemente umfassen eine der Objektebene unmittelbar folgende erste Gruppe 14 sowie ein letztes optisches Element 15, das der ersten Gruppe 14 folgt und der Bildebene 12 am nächsten liegt. Das letzte optische Element wird im folgenden auch als Abschlusselement 15 bezeichnet; es kann aus einer oder mehreren Komponenten bestehen. Die der Bildebene zugewandte Austrittsfläche 16 des Abschlusselementes bildet gleichzeitig die Austrittsfläche 16 des Projektionsobjektives. Diese ist in einem Arbeitsabstand von wenigen Millimetern zur Bildebene angeordnet. Das Abschlusselement 15 ist eine planparallele Platte aus Quarzglas und ist somit brechkraftfrei und ohne Durchbiegung. Zwischen der ersten Gruppe 14 und dem Abschlusselement 16 besteht ein relativ großer Abstand von einigen Millimetern, der eine axiale Verschiebung bzw. Verlagerung des Abschlusselementes 16 in Richtung der ersten Gruppe 14 ermöglicht. Das Projektionsobjektiv 10 ist in seiner Immersionskonfiguration gezeigt und somit als Immersionsobjektiv ausgelegt. Dies bedeutet, dass es bezüglich der erzeugten Bildfehler (Aberrationen) darauf abgestimmt ist, dass der Bildraum 17 zwischen Austrittsfläche 16 und Bildebene 12 mit einem Immersionsmedium 18 gefüllt ist, dessen Brechungsindex deutlich größer als 1 ist. Im Beispielsfall wird eine Immersionsflüssigkeit verwendet, die bei einer Arbeitswellenlänge von 248 nm einen Brechungsindex $n_I$ = 1,4 hat.

Die erste Gruppe 14 optischer Elemente ist insgesamt so ausgelegt, dass eine durchtretende Wellenfront hinter der ersten Gruppe bzw. vor der Eintrittsfläche 19 des letzten Elementes sphärisch unterkorrigiert ist. Dieser Korrektionszustand wird durch das nebenstehende Diagramm (a) veranschaulicht, welches für einen axialen Feldpunkt den Korrektionszustand als Queraberration darstellt. Die starke Abweichung der Aberrationskurve von der Null-Linie symbolisiert eine betragsmäßig große sphärische Unterkorrektur.

Bekanntlich führen planparallele Platten für sich genommen eine sphärische Überkorrektur ein, die mit der Dicke der Platte zunimmt und mit steigendem Brechungsindex des Materials abnimmt (siehe Formel zur Berechnung von SPH). Entsprechend ist die Wellenfront nach Durchtritt durch die planparallele Platte 15 weniger stark unterkorrigiert als vor Eintritt in die Platte. Dies ist in Diagramm (b) schematisch dargestellt.

Die dünne Immersionsschicht 18, deren Brechungsindex vom Brechungsindex der Platte 15 abweicht, wirkt ebenfalls wie eine planparallele Platte und führt weitere sphärische Überkorrektur ein.

Im Beispielsfall sind die Dicke der Abschlussplatte 16 sowie deren Brechungsindex und die Dicke der Immersionsschicht 18 und deren Brechungsindex und die sphärische Unterkorrektur der ersten Gruppe 14 so aufeinander abgestimmt, dass die Wellenfront in der Bildebene 12 bezüglich sphärischer Aberration im Wesentlichen vollständig korrigiert ist (Diagramm (c)). Daher ist in dieser Immersionskonfiguration eine hinreichend gut korrigierte Abbildung möglich.

Anhand der Figuren 2 bis 4 wird nun ein Verfahren zur Abstimmung des Projektionsobjektives erläutert, welches es ermöglicht, das gleiche Projektionsobjektiv mit wenigen strukturellen Änderungen als Trockenobjektiv mit gutem Korrektionszustand zu verwenden. Die in den Figuren 2 bis 4 gezeigten Verfahrensschritte können in der gezeigten oder in einer anderen Reihenfolge oder mindestens teilweise gleichzeitig durchgeführt werden. Bei der gezeigten Verfahrensvariante wird in einem ersten Schritt das Immersionsmedium 18 aus dem Bildraum entfernt (Fig. 2). Diese isolierte Maßnahme ändert nichts am Korrektionszustand vor Eintritt in das Abschlusselement 16 (Diagramm (a)) und am Austritt des Abschlusselementes Diagramm (b)). Jedoch wird durch Entfernung der hochbrechenden, planparallelen Schicht aus Immersionsfluid aus dem Bildraum deren überkorrigierende Wirkung weggenommen, so dass der Korrektionszustand in der Bildebene 12 dem unterkorrigierten Korrektionszustand an der Austrittsfläche 16 entspricht (Vergleiche Diagramme (b) und (c).

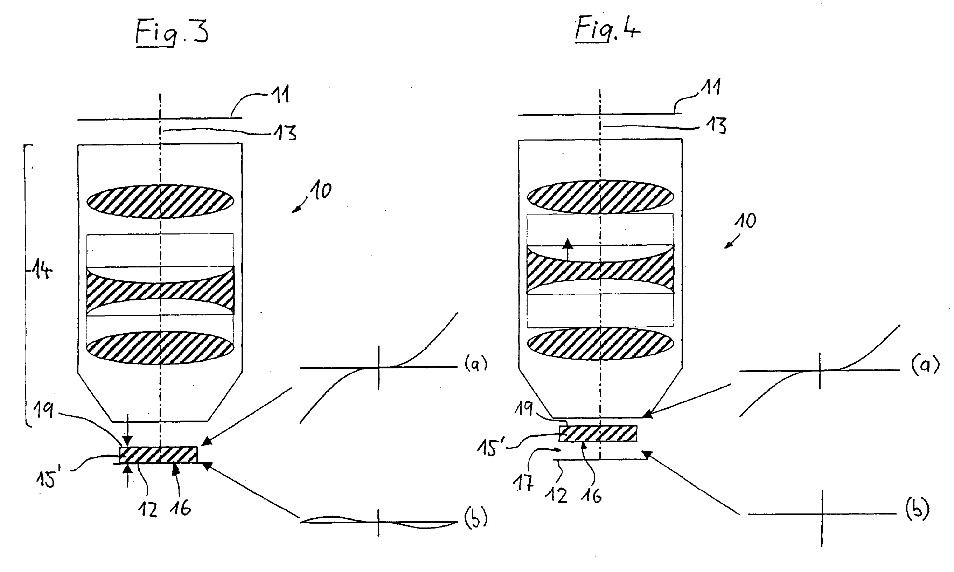

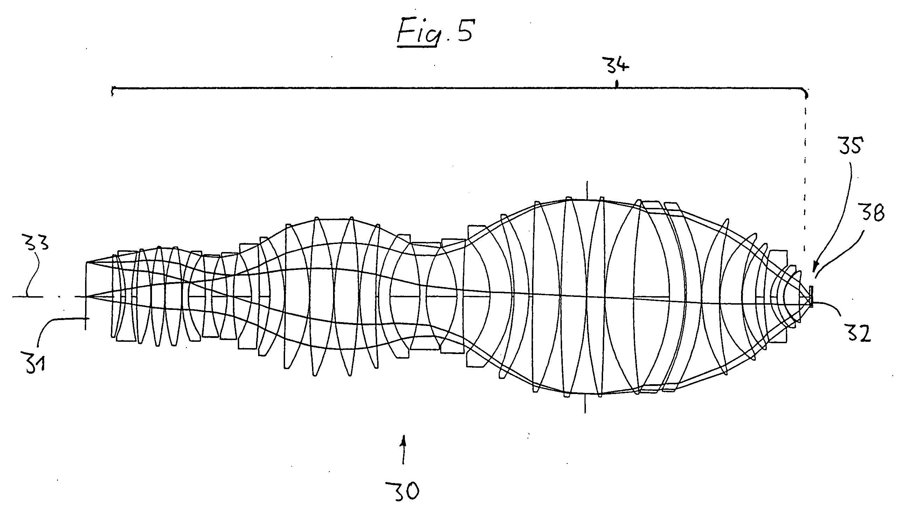

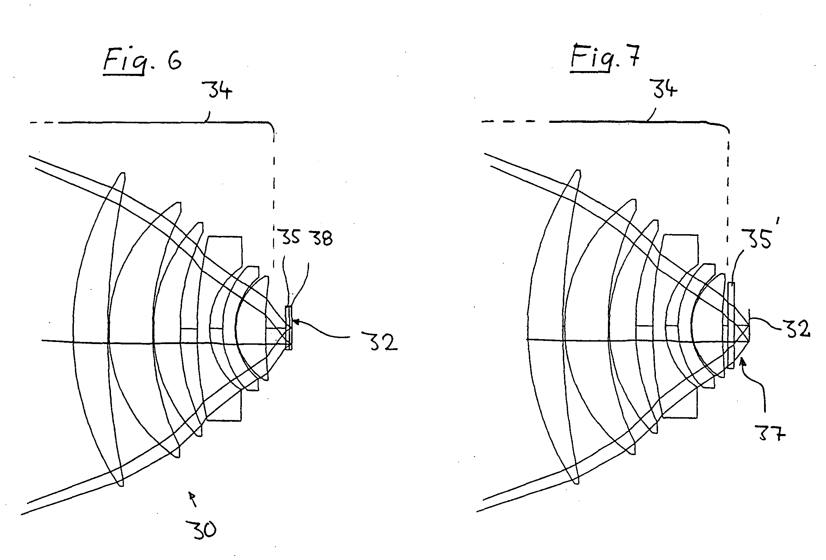

In einem weiteren Schritt (Fig. 3) wird nun die Dicke des letzten optischen Elementes 16 vergrößert. Dabei wird deren überkorrigierende Wirkung mit steigender Dicke zunehmen. Die Dicke wird entsprechend dem Brechungsindex des Plattenmaterials so weit gewählt, dass die durch die dickere Platte 16' bewirkte Überkorrektur den unterkorrigierten Korrektionszustand am Platteneintritt 19 (Diagramm (a)) weitgehend kompensiert. Der mit dieser Maßnahme bei diesem Projektionsobjektiv erzielbare Projektionszustand in der Bildebene ist im Diagramm (b) gezeigt, welches in Richtung der Ordinate eine vergrößerte Skala aufweist, um den Restfehler bildlich darstellen zu können. Es ist erkennbar, dass im Beispielsfall in der Mitte und am Rand der Pupille ein sehr guter Korrektionszustand erreicht ist, während überwiegend in der Pupillenzone eine leichte Überkorrektur vorliegt.

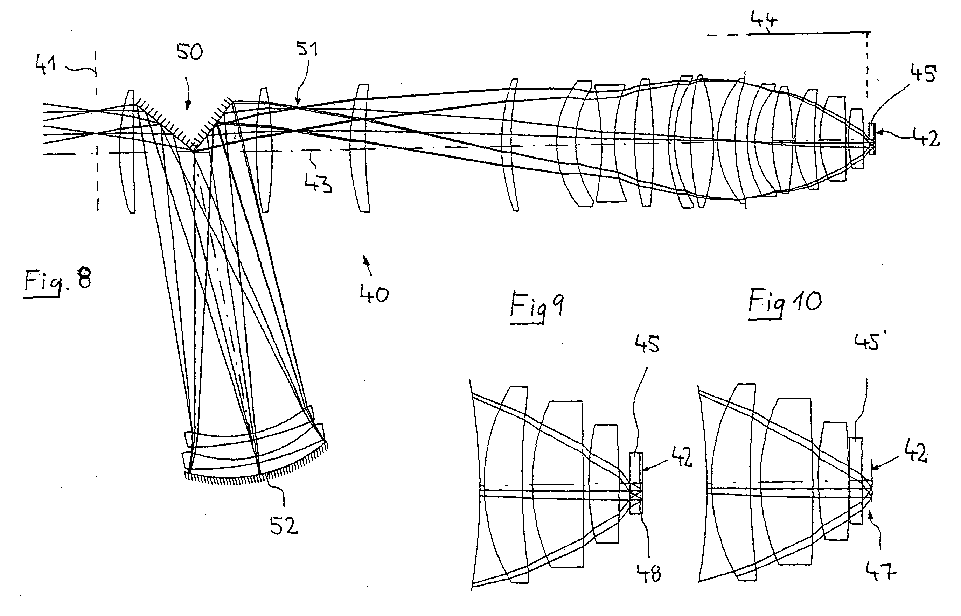

Bei der hier dargestellten Verfahrensvariante wird nun das Projektionsobjektiv in zwei weiteren Schritten in seine in Fig. 4 gezeigten Trockenkonfiguration überführt. Ein Schritt besteht darin, durch axiale Verlagerung des letzten optischen Elementes 15' in Richtung der ersten Gruppe 14 einen im Vergleich zur Immersionskonfiguration (Fig. 1) größeren Arbeitsabstand einzustellen. Dies kann durch axiale Verschiebung des Elementes 15' mit Hilfe eines elektrisch oder auf andere Weise antreibbaren z-Manipulators geschehen. Es ist auch möglich, dass letzte optische Element einzeln zu fassen und mit Hilfe von Abstandhaltern zwischen den Fassungen der ersten Gruppe und der Fassung des letzten optischen Elementes einen geeigneten Abstand durch Ausbau bzw. Einbau von Abstandhaltern einzustellen. Da die planparallele Platte 16 weitestgehend brechkraftfrei und ohne Durchbiegung ist, kann diese axiale Verlagerung durchgeführt werden, ohne dass dies einen meßbaren Einfluss auf die Aberrationen des Objektivs hat.

Ohne weitere Maßnahmen würde daher der Korrektionszustand der Trockenkonfiguration gemäß Fig. 4 demjenigen von Fig. 3 (b) entsprechen. Jedoch ist bei der gezeigten Ausführungsform in der ersten Gruppe mindestens eine der Linsen, nämlich gezeigte Negativlinse 20, mit Hilfe eines z-Manipulators axial verschiebbar gelagert. Der in Fig. 3 (b) gezeigte Restfehler kann in diesem Fall durch leichte Verschiebung der Linse 20 Richtung Objektebene (Pfeil) kompensiert werden, so dass das fertig abgestimmte Trockenobjektiv am Lichtaustritt einen hinreichend guten Korrektionszustand hat (Diagramm (b)).

Dieser letzte Schritt, nämlich die Feinabstimmung mit Hilfe mindestens eines manipulierbaren oder veränderbaren optischen Elementes der ersten Gruppe, kann häufig erforderlich sein, um enge Spezifikationen einhalten zu können. Bei geringeren Anforderungen können die erstgenannten Schritte (Änderung des Brechungsindex im Bildraum durch Einführen oder Entnahme eines Immersionsfluids, Veränderung der Dicke des letzten Elementes sowie Verlagerung des letzten Elementes zur Änderung des Arbeitsabstandes) ausreichen, um eine Umkonfiguration zwischen Immersionskonfiguration und Trockenkonfiguration (oder umgekehrt) zu erreichen.

Diese Verfahrensschritte sind aus Darstellungsgründen zum Teil getrennt dargestellt. In der Praxis werden die Veränderungen der Dicke des Abschlußelementes und dessen axiale Verlagerung häufig dadurch realisiert, dass ein gesondert gefasstes Abschlußelement gegebener Dicke und Axialposition ausgebaut und gegen ein entsprechend gefasstes mit anderer Axialposition und Dicke ausgetauscht wird.

Im folgenden wird anhand konkreter Ausführungsformen refraktiver und katadioptrischer Projektionsobjektive die Ausführbarkeit der Erfindung auch bei Hochleistungs-Projektionsobjektiven für die Mikrolithografie demonstriert. Fig. 5 zeigt beispielhaft ein rein refraktives, rotationssymmetrisches Projektionsobjektiv 30 für die hochauflösende Mikrolithografie, besonders im DUV-Wellenlängenbereich. Das Design entspricht im Wesentlichen demjenigen Objektiv, das in der DE 198 55 108 (entsprechend US 6,349,005 B1) gezeigt und dort ausführlich dargestellt ist. Die diesbezügliche Offenbarung dieser Schriften wird durch Bezugnahme zum Inhalt dieser Beschreibung gemacht.

Das Dreibauchsystem ist für 248 nm Arbeitswellenlänge ausgelegt, hat bei einem Wert NA = 0,8 eine Feldgröße von 26 mm · 8 mm und hat ausschließlich Linsen aus synthetischem Quarzglas. In Tabelle 1 ist die Spezifikation des Designs in tabellarischer Form zusammengefasst. Dabei gibt Spalte 1 die Nummer der brechenden oder auf andere Weise ausgezeichneten Flächen, Spalte 2 den Radius der Flächen (in mm), Spalte 3 den als Dicke bezeichneten Abstand der Fläche zur nachfolgenden Fläche (in mm), Spalte 4 das Material, Spalte 5 die Brechzahl des Materials bei der Arbeitswellenlänge und Spalte 6 den maximal nutzbaren Radius (halber freier Durchmesser) an. Die Gesamtlänge L zwischen Objektebene und Bildebene beträgt ca. 1166 mm. Alle Krümmungen sind sphärisch.

Figur 5 und die vergrößerte Darstellung des waferseitigen Endbereiches in Figur 6 zeigen das System in seiner Immersionskonfiguration (Tabelle 1). Es ist erkennbar, dass zwischen der ersten Gruppe 34 optischer Elemente und dem letzten Element 35 ein relativ großer Abstand von etwa 16,25 mm besteht. Als letztes optisches Element 35 dient eine planparallele Platte (Flächen 65, 66) mit einer Dicke von 3 mm, die unmittelbar an eine ca. 2 mm dicke Immersionsschicht 38 aus deionisiertem Wasser angrenzt, welches den Raum zwischen der Austrittsfläche des Elementes 35 bzw. des Projektionsobjektivs und der Bildebene 32 ausfüllt. Der Korrektionszustand des Systems in dieser Immersionskonfiguration kann beispielsweise durch eine Wellenfrontaberration von ca. 13 mλ rms angegeben werden.

Wird das System durch die oben erläuterten Verfahrensschritte in eine Trockenkonfiguration überführt, so nimmt der waferseitige Endbereich die in Figur 7 ausschnittsweise dargestellte Gestaltung an. Die Spezifikation im Einzelnen ist in Tabelle 2 angegeben. Es ist erkennbar, dass die Abschlussplatte 35 deutlich näher an das letzte Element der ersten Gruppe 34 herangerückt ist, wodurch sich der Arbeitsabstand 37 von ca. 2 mm auf ca. 12 mm vergrößert hat. Die Dicke der Platte hat von 3 mm auf ca. 5 mm zugenommen. Im Beispielsfall wurde dies durch Auswechslung der dünnen Platte 35 von Figur 6 gegen eine entsprechend dickere Platte 35' (Figur 7) erreicht. Hierzu sind die Platten einzeln gefasst und jeweils so dimensioniert, dass durch Austausch der einzelnen Fassungen gleichzeitig auch der richtige Axialabstand zwischen der ersten Gruppe 34 und dem Abschlusselement eingestellt ist. Bei anderen Ausführungsform ist eine axiale Verschiebung der Endplatte mit Hilfe eines z-Manipulators vorgesehen. Die Dickenzunahme zwischen Immersions- und Trockenkonfiguration wird dadurch erreicht, dass an die in der Immersionskonfiguration vorhandene dünnere Platte eine dünne Platte mit ca. 2 mm Dicke angesprengt wird. Durch diese optisch neutrale Verbindung wird ein letztes optisches Element aus zwei Komponenten geschaffen, die voneinander trennbar sind, um die Dickenänderung des Abschlusselementes ohne Ausbau zu ermöglichen.

Anhand der Figuren 8 bis 10 wird ersichtlich, dass die Erfindung nicht auf refraktive Systeme beschränkt ist, sondern auch bei katadioptrischen Projektionsobjektiven einsetzbar ist. Das katadioptrische Projektionsobjektiv 40 mit geometrischem Strahlteiler 50 ist dazu vorgesehen, eine in seiner Objektebene 41 liegendes Muster im Maßstab 4:1 unter Erzeugung eines reellen Zwischenbildes 51 in die Bildebene 42 abzubilden. Die optische Achse 43 wird am geometrischen Strahlteiler 50 gefaltet, um bei der Abbildung einen Konkavspiegel 52 nutzen zu können, der die chromatische Korrektur des Gesamtsystems erleichtert. Der Prinzipaufbau des Projektionsobjektivs und seine optischen Eigenschaften können im Einzelnen der DE 101 27 227 (entsprechend EP 1 260 845) entnommen werden, deren Offenbarungsgehalt durch Bezugnahme zum Inhalt dieser Beschreibung gemacht wird.

Figuren 8 und 9 sowie Tabelle 3 geben die Eigenschaften der Immersionskonfiguration wieder, während Figur 10 und Tabelle 4 die entsprechende Trockenkonfiguration offenbaren. Die in Spalte 2 der Tabellen mit "AS" zu gekennzeichneten Flächen sind asphärisch, die Flächenform kann anhand der Asphärendaten der Tabellen und der in EP 1 260 845 genannten Formel berechnet werden. Das Projektionsobjektiv 40 ist für eine Arbeitswellenlänge von ca. 157 nm ausgelegt, bei der das für alle Linsen verwendete Linsenmaterial Calciumfluorid einen Brechungsindex N = 1,55841 hat. Die bildseitige numerische Apertur beträgt NA = 0,8, das System ist für eine Feldgröße von $22 \cdot 7 \ mm^2$ ausgelegt und doppelt telezentrisch.

In der Immersionskonfiguration (Figuren 8 und 9) liegt das weitgehend planparallele, in Kontakt mit der Immersionsschicht 48 stehende Abschlusselement 45 (Flächen 46, 47) in einem Arbeitsabstand von 2 mm von der Bildebene 42 und hat eine Dicke von ca. 8 mm. Der Korrektionszustand dieser Immersionskonfiguration kann beispielsweise durch eine Wellenfrontaberration von ca. 8 mλ rms angegeben werden.

In der in Figur 10 und Tabelle 4 gezeigten Trockenkonfiguration liegt ein vergrößerter Arbeitsabstand von ca. 7,8 mm vor, weil die Abschlussplatte näher zur ersten Gruppe 44 gerückt ist. Die Dicke der Abschlussplatte 45' hat zwischen Immersionskonfiguration und Trockenkonfiguration auf ca. 9,7 mm zugenommen. Der Korrektionszustand kann beispielsweise durch eine Wellenfrontaberration von ca. 8 mλ rms angegeben werden.

Im Folgenden werden verschiedene Korrekturmaßnahmen erläutert, die es ermöglichen, einen evtl. zu beseitigenden Restfehler nach der oben beschriebenen Grundabstimmung zu vermindern. Eine der Möglichkeiten besteht darin, eine der sphärischen Linsenflächen der ersten Gruppe mit einer zusätzlichen Nanoasphäre zu versehen. Als Nanoasphäre wird hier eine asphärische Flächenform bezeichnet, die nur geringfügig (im Nanometerbereich) von einer Sphäre abweicht und dadurch relativ leicht aus einer sphärischen Linse herstellbar ist. Das katadioptrische Trockensystem mit zusätzlicher Nanoasphäre ist in Tabelle 5 dargestellt. Hier ist erkennbar, dass die ursprünglich sphärische Fläche 32 nun als asphärische Fläche ausgebildet ist. Das kann durch Austausch entsprechend unterschiedlicher Linsen oder durch Ausbau, Oberflächenbearbeitung, Beschichtung und nachfolgendem Einbau erreicht werden. Der Korrektionszustand des Systems hat sich dadurch deutlich verbessert. Er kann beispielsweise durch eine Wellenfrontaberration von ca. 8 mλ rms angegeben werden.

Eine Beseitigung von Restfehlern ist auch dadurch möglich, dass der Lichtleitwert des Gesamtsystems (Produkt aus numerischer Apertur und Feldgröße) verkleinert wird. Hierdurch entspannen sich insgesamt die Anforderungen an das Design. Beispielhaft ist in Tabelle 6 das in Figuren 8 bis 10 gezeigte System gezeigt, das eine kleinere Feldgröße von 20 mm · 5 mm ausgelegt wurde. Hierdurch lässt sich ein ausreichend guter Korrekturzustand erzielen, der beispielsweise durch eine Wellenfrontaberration von ca. 9 mλ rms angegeben werden kann.

Im Rahmen der Erfindung ist es auch möglich, dass das letzte optische Element, z.B. eine Abschlußplatte, aus dem Projektionsobjektiv entfernt wird anstatt dieser eine im Vergleich zur Austrittsfläche des Projektionsobjektives grosse Planparalellplatte geeigneter, insbesondere anderer Dicke, verwendet wird, die sich über den gesamten Wafer oder einen großen Teil seiner Fläche erstreckt. Diese Planparallelplatte wird nun, zusammen mit der Immersionsflüssigkeit, auf den Wafer gelegt und durch diese Platten-Immersionskombination hindurch belichtet. Das "Rest-Projektionsobjektiv" hat dabei starke sphärische Unterkorrektur. Es kann ggf. wie oben beschrieben noch abgestimmt werden.

Es ist unter Nutzung der Erfindung auch möglich, Projektionsobjektive abzustimmen, bei denen das letzte optische Element zunächst nicht im wesentlichen brechkraftfrei und im wesentlichen ohne Durchbiegung ist, sondern beispielsweise durch eine Plankonvexlinse mit sphärischer oder asphärischer Eintrittsseite sowie weitgehend oder vollständig ebener Austrittsseite gebildet wird. In diesem Fall kann man zur Erzeugung einer Immersionskonfiguration von diesem Element eine Planplatte abspalten on damit seine Dicke verringern. Andere Abstimmungsmassnahmen können analog zu den obigen Erläuterungen ausgeführt werden.

Die Erfindung schafft Kombi-Projektionsobjektive, die sowohl als Trockenobjektiv als auch als Immersionsobjektiv einsetzbar sind. Durch geeignete Wahl von Designparametern wird es möglich, erfindungsgemäß aufgebaute "Trockenobjektive" mit geringem Aufwand zu einem "Immersionsobjektiv" abzustimmen bzw. umgekehrt. Bei erfindungsgemäßen Trockenobjektiven sind nur relativ einfache Änderungen am Aufbau erforderlich, um eine Nutzung als Immersionssystem zu ermöglichen und um damit dem Nutzer einen Belichtungsprozess mit größerer Tiefenschärfe zu erlauben. Zusätzlich können sich Gewinne bei der Auflösung einstellen. Nach Abstimmung einer Immersion- zu einer Trockenkonfiguration können die Vorteile der "trockenen" Lithographie genutzt werden.

Die Erfindung kann bei rein refraktiven Systemen genauso genutzt werden wie bei katadioptrischen Systemen mit und ohne Strahlteiler, wobei bei Strahlteilersystemen sowohl Systeme mit physikalischem Strahlteiler (z.B. beam splitter desingns) als auch Systeme mit geometrischem Strahlteiler in Betracht kommen. Weitere Beispiele geeigneter refraktiver Systeme sind zB in den Veröffentlichungen EP 1 245 984, EP 1 235 091 oder US 6,008,884 gezeigt. Ein geeignetes System katadioptrisches System mit geometrischem Strahlteiler ist in der US-Patentanmeldung US 2002/0145811 gezeigt. Bei den beiden letztgenannten Schriften sind Systeme mit letzten Elementen in Form von Plankonvexlinsen gezeigt, die in der beschriebenen Weise mit einer Abspaltung einer Planplatte und begleitenden Massnahmen abstimmbar sind. Die Offenbarungen dieser Schriften werden durch Bezugnahme zum Inhalt dieser Beschreibung gemacht und können mit der vorliegenden Erfindung kombiniert werden.

TABELLE 1

| j29o | | | | | |
|---|---|---|---|---|---|
| FLAECHE | RADIEN | DICKEN | GLAESER | BRECHZAHL 248.38 nm | 1/2 FREIER DURCHMESSER |
| 0 | 0.000000000 | 32.000000000 | | 1.00000000 | 54.410 |
| 1 | 0.000000000 | 10.587540450 | L710 | 0.99998200 | 61.093 |
| 2 | -2417.351767120 | 13.126300000 | SUPRA1 | 1.50833811 | 63.132 |
| 3 | -248.195466920 | 7.359264018 | L710 | 0.99998200 | 63.945 |
| 4 | -168.131361870 | 10.000000000 | SUPRA1 | 1.50833811 | 64.202 |
| 5 | 328.986124739 | 7.907519166 | L710 | 0.99998200 | 70.046 |
| 6 | 671.742152743 | 22.614900000 | SUPRA1 | 1.50833811 | 71.945 |
| 7 | -219.346865952 | 1.054978296 | L710 | 0.99998200 | 73.402 |
| 8 | 351.854459479 | 21.378800000 | SUPRA1 | 1.50833811 | 77.449 |
| 9 | -417.329819985 | 0.748356148 | L710 | 0.99998200 | 77.668 |
| 10 | 266.259242017 | 26.426700000 | SUPRA1 | 1.50833811 | 76.971 |
| 11 | -418.068287643 | 0.747164758 | L710 | 0.99998200 | 75.964 |
| 12 | 195.049526899 | 10.000000000 | SUPRA1 | 1.50833811 | 69.816 |
| 13 | 112.784218098 | 27.264697553 | L710 | 0.99998200 | 64.221 |
| 14 | -548.976305020 | 10.000000000 | SUPRA1 | 1.50833811 | 63.660 |
| 15 | 167.581609987 | 25.042515270 | L710 | 0.99998200 | 61.992 |
| 16 | -203.629259785 | 10.000000000 | SUPRA1 | 1.50833811 | 62.349 |
| 17 | 360.120642869 | 28.995838980 | L710 | 0.99998200 | 66.965 |
| 18 | -127.653905514 | 12.696400000 | SUPRA1 | 1.50833811 | 68.153 |
| 19 | -1103.725724970 | 17.018787360 | L710 | 0.99998200 | 81.984 |
| 20 | -225.898831342 | 23.521200000 | SUPRA1 | 1.50833811 | 84.684 |
| 21 | -171.063497139 | 1.574450554 | L710 | 0.99998200 | 92.606 |
| 22 | -22770.163604600 | 38.438000000 | SUPRA1 | 1.50833811 | 109.997 |
| 23 | -229.816390281 | 0.749282985 | L710 | 0.99998200 | 113.270 |
| 24 | 1170.594630540 | 38.363100000 | SUPRA1 | 1.50833811 | 123.579 |
| 25 | -320.184892150 | 0.749629640 | L710 | 0.99998200 | 124.514 |
| 26 | 335.012872058 | 39.596800000 | SUPRA1 | 1.50833811 | 124.658 |
| 27 | -764.462984962 | 2.214257730 | L710 | 0.99998200 | 123.947 |
| 28 | 270.136227728 | 25.935800000 | SUPRA1 | 1.50833811 | 112.963 |
| 29 | 1248.618077510 | 4.352014987 | L710 | 0.99998200 | 110.825 |
| 30 | 177.098661261 | 18.578800000 | SUPRA1 | 1.50833811 | 96.632 |
| 31 | 131.459110961 | 48.405871098 | L710 | 0.99998200 | 84.997 |
| 32 | -254.431714105 | 10.000000000 | SUPRA1 | 1.50833811 | 83.694 |
| 33 | 149.734192113 | 49.515509852 | L710 | 0.99998200 | 77.858 |
| 34 | -137.204786283 | 10.000000000 | SUPRA1 | 1.50833811 | 78.232 |
| 35 | 1410.223675540 | 43.391488727 | L710 | 0.99998200 | 89.345 |

TABELLE 1   (fortgesetzt)

**j29o**

| FLAECHE | RADIEN | DICKEN | GLAESER | BRECHZAHL 248.38 nm | 1/2 FREIER DURCHMESSER |
|---|---|---|---|---|---|
| 36 | -134.825941720 | 35.292100000 | SUPRA1 | 1.50833811 | 91.736 |
| 37 | -168.418502871 | 3.480235112 | L710 | 0.99998200 | 110.924 |
| 38 | -350.805989269 | 24.010800000 | SUPRA1 | 1.50833811 | 123.372 |
| 39 | -244.301424027 | 6.015284795 | L710 | 0.99998200 | 128.258 |
| 40 | 4941.534628580 | 43.549100000 | SUPRA1 | 1.50833811 | 147.192 |
| 41 | -357.889527255 | 2.367042190 | L710 | 0.99998200 | 149.417 |
| 42 | 1857.663670230 | 40.932000000 | SUPRA1 | 1.50833811 | 156.043 |
| 43 | -507.091567715 | -0.213252954 | L710 | 0.99998200 | 156.763 |
| 44 | 0.000000000 | 0.962846248 | L710 | 0.99998200 | 155.516 |
| 45 | 637.188120359 | 28.431900000 | SUPRA1 | 1.50833811 | 156.869 |
| 46 | -4285.746531360 | 0.749578310 | L710 | 0.99998200 | 156.617 |
| 47 | 265.928249908 | 45.432900000 | SUPRA1 | 1.50833811 | 152.353 |
| 48 | 1127.170329670 | 57.049328626 | L710 | 0.99998200 | 150.272 |
| 49 | -273.057181282 | 24.571800000 | SUPRA1 | 1.50833811 | 149.389 |
| 50 | -296.450446798 | 2.401860529 | L710 | 0.99998200 | 150.065 |
| 51 | -317.559071036 | 23.847600000 | SUPRA1 | 1.50833811 | 148.110 |
| 52 | -297.103672940 | 0.819938446 | L710 | 0.99998200 | 148.158 |
| 53 | 223.869192775 | 28.117900000 | SUPRA1 | 1.50833811 | 122.315 |
| 54 | 548.591751129 | 0.749776549 | L710 | 0.99998200 | 120.110 |
| 55 | 123.937471688 | 34.861300000 | SUPRA1 | 1.50833811 | 99.291 |
| 56 | 211.883788830 | 0.738299719 | L710 | 0.99998200 | 93.879 |
| 57 | 121.391085072 | 21.109500000 | SUPRA1 | 1.50833811 | 82.929 |
| 58 | 178.110541498 | 13.722409422 | L710 | 0.99998200 | 77.266 |
| 59 | 314.102464129 | 10.000000000 | SUPRA1 | 1.50833811 | 71.524 |
| 60 | 60.563892001 | 10.471596266 | L710 | 0.99998200 | 49.697 |
| 61 | 71.706607533 | 10.069000000 | SUPRA1 | 1.50833811 | 48.032 |
| 62 | 53.184242317 | 0.713865261 | L710 | 0.99998200 | 40.889 |
| 63 | 48.728728866 | 24.194000000 | SUPRA1 | 1.50833811 | 39.865 |
| 64 | 325.049018458 | 16.249640231 | L710 | 0.99998200 | 35.979 |
| 65 | 0.000000000 | 3.000000000 | SUPRA1 | 1.50833811 | 16.879 |
| 66 | 0.000000000 | 2.000000000 | IMMERS | 1.40000000 | 14.998 |
| 67 | 0.000000000 | 0.000000000 | | 1.00000000 | 13.603 |

TABELLE 2

**j30o**

| FLAECHE | RADIEN | DICKEN | GLAESER | BRECHZAHL 248.38 nm | 1/2 FREIER DURCHMESSER |
|---|---|---|---|---|---|
| 0 | 0.000000000 | 32.000000000 | | 1.00000000 | 54.410 |
| 1 | 0.000000000 | 10.283889256 | L710 | 0.99998200 | 61.093 |
| 2 | -2417.351767120 | 13.126300000 | SUPRA1 | 1.50833811 | 63.069 |
| 3 | -248.195466920 | 7.293007084 | L710 | 0.99998200 | 63.884 |
| 4 | -168.131361870 | 10.000000000 | SUPRA1 | 1.50833811 | 64.137 |
| 5 | 328.986124739 | 8.273191790 | L710 | 0.99998200 | 69.971 |
| 6 | 671.742152743 | 22.614900000 | SUPRA1 | 1.50833811 | 72.045 |
| 7 | -219.346865952 | 0.447882685 | L710 | 0.99998200 | 73.489 |
| 8 | 351.854459479 | 21.378800000 | SUPRA1 | 1.50833811 | 77.419 |

TABELLE 2   (fortgesetzt)

| j30o | | | | | |
|---|---|---|---|---|---|
| FLAECHE | RADIEN | DICKEN | GLAESER | BRECHZAHL 248.38 nm | 1/2 FREIER DURCHMESSER |
| 9 | -417.329819985 | 0.643718463 | L710 | 0.99998200 | 77.636 |
| 10 | 266.259242017 | 26.426700000 | SUPRA1 | 1.50833811 | 76.935 |
| 11 | -418.068287643 | 1.297611013 | L710 | 0.99998200 | 75.923 |
| 12 | 195.049526899 | 10.000000000 | SUPRA1 | 1.50833811 | 69.627 |
| 13 | 112.784218098 | 26.146948060 | L710 | 0.99998200 | 64.049 |
| 14 | -548.976305020 | 10.000000000 | SUPRA1 | 1.50833811 | 63.646 |
| 15 | 167.581609987 | 26.480913850 | L710 | 0.99998200 | 61.963 |
| 16 | -203.629259785 | 10.000000000 | SUPRA1 | 1.50833811 | 62.465 |
| 17 | 360.120642869 | 28.474843347 | L710 | 0.99998200 | 67.077 |
| 18 | -127.653905514 | 12.696400000 | SUPRA1 | 1.50833811 | 68.070 |
| 19 | -1103.725724970 | 17.347391549 | L710 | 0.99998200 | 81.856 |
| 20 | -225.898831342 | 23.521200000 | SUPRA1 | 1.50833811 | 84.765 |
| 21 | -171.063497139 | 1.525859924 | L710 | 0.99998200 | 92.671 |
| 22 | -22770.163604600 | 38.438000000 | SUPRA1 | 1.50833811 | 110.016 |
| 23 | -229.816390281 | 0.449372011 | L710 | 0.99998200 | 113.280 |
| 24 | 1170.594630540 | 38.363100000 | SUPRA1 | 1.50833811 | 123.463 |
| 25 | -320.184892150 | 0.449220757 | L710 | 0.99998200 | 124.404 |
| 26 | 335.012872058 | 39.596800000 | SUPRA1 | 1.50833811 | 124.508 |
| 27 | -764.462984962 | 0.448529485 | L710 | 0.99998200 | 123.785 |
| 28 | 270.136227728 | 25.935800000 | SUPRA1 | 1.50833811 | 113.275 |
| 29 | 1248.618077510 | 4.599063715 | L710 | 0.99998200 | 111.173 |
| 30 | 177.098661261 | 18.578800000 | SUPRA1 | 1.50833811 | 96.787 |
| 31 | 131.459110961 | 48.903368693 | L710 | 0.99998200 | 85.123 |
| 32 | -254.431714105 | 10.000000000 | SUPRA1 | 1.50833811 | 83.644 |
| 33 | 149.734192113 | 49.544589669 | L710 | 0.99998200 | 77.792 |
| 34 | -137.204786283 | 10.000000000 | SUPRA1 | 1.50833811 | 78.174 |
| 35 | 1410.223675540 | 43.113042129 | L710 | 0.99998200 | 89.233 |
| 36 | -134.825941720 | 35.292100000 | SUPRA1 | 1.50833811 | 91.558 |
| 37 | -168.418502871 | 4.049119334 | L710 | 0.99998200 | 110.696 |
| 38 | -350.805989269 | 24.010800000 | SUPRA1 | 1.50833811 | 123.308 |
| 39 | -244.301424027 | 5.341877309 | L710 | 0.99998200 | 128.188 |
| 40 | 4941.534628580 | 43.549100000 | SUPRA1 | 1.50833811 | 146.729 |
| 41 | -357.889527255 | 4.028668923 | L710 | 0.99998200 | 148.997 |
| 42 | 1857.663670230 | 40.932000000 | SUPRA1 | 1.50833811 | 155.818 |
| 43 | -507.091567715 | -1.371361371 | L710 | 0.99998200 | 156.540 |
| 44 | 0.000000000 | 2.120040201 | L710 | 0.99998200 | 155.343 |
| 45 | 637.188120359 | 28.431900000 | SUPRA1 | 1.50833811 | 156.764 |
| 46 | -4285.746531360 | 0.447699567 | L710 | 0.99998200 | 156.510 |
| 47 | 265.928249908 | 45.432900000 | SUPRA1 | 1.50833811 | 152.266 |
| 48 | 1127.170329670 | 56.966580248 | L710 | 0.99998200 | 150.172 |
| 49 | -273.057181282 | 24.571800000 | SUPRA1 | 1.50833811 | 149.291 |
| 50 | -296.450446798 | 2.661459751 | L710 | 0.99998200 | 149.961 |
| 51 | -317.559071036 | 23.847600000 | SUPRA1 | 1.50833811 | 147.915 |
| 52 | -297.103672940 | 0.449161173 | L710 | 0.99998200 | 147.956 |
| 53 | 223.869192775 | 28.117900000 | SUPRA1 | 1.50833811 | 122.290 |
| 54 | 548.591751129 | 1.339172987 | L710 | 0.99998200 | 120.081 |
| 55 | 123.937471688 | 34.861300000 | SUPRA1 | 1.50833811 | 99.087 |

TABELLE 2   (fortgesetzt)

| j30o | | | | | |
|---|---|---|---|---|---|
| FLAECHE | RADIEN | DICKEN | GLAESER | BRECHZAHL 248.38 nm | 1/2 FREIER DURCHMESSER |
| 56 | 211.883788830 | 0.952940583 | L710 | 0.99998200 | 93.588 |
| 57 | 121.391085072 | 21.109500000 | SUPRA1 | 1.50833811 | 82.604 |
| 58 | 178.110541498 | 13.676325222 | L710 | 0.99998200 | 76.860 |
| 59 | 314.102464129 | 10.000000000 | SUPRA1 | 1.50833811 | 71.076 |
| 60 | 60.563892001 | 10.077651049 | L710 | 0.99998200 | 49.477 |
| 61 | 71.706607533 | 10.069000000 | SUPRA1 | 1.50833811 | 47.911 |
| 62 | 53.184242317 | 0.732248727 | L710 | 0.99998200 | 40.780 |
| 63 | 48.728728866 | 24.194000000 | SUPRA1 | 1.50833811 | 39.753 |
| 64 | 325.049018458 | 4.167687088 | L710 | 0.99998200 | 35.772 |
| 65 | 0.000000000 | 5.000000000 | SUPRA1 | 1.50833811 | 32.831 |
| 66 | 0.000000000 | 12.000000000 | L710 | 0.99998200 | 29.694 |
| 67 | 0.000000000 | 0.000000000 | | 1.00000000 | 13.603 |

EP 1 431 826 A2

TABELLE 3

j31o

| FLAECHE | RADIEN | DICKEN | GLAESER | BRECHZAHL 157.63 nm | 1/2 FREIER DURCHMESSER |
|---|---|---|---|---|---|
| 0 | 0.000000000 | 38.482288093 | | 1.00000000 | 85.333 |
| 1 | 304.292982078 | 22.168809366 | CAF2HL | 1.55840983 | 92.476 |
| 2 | 2741.794481050 | 96.128678854 | | 1.00000000 | 92.204 |
| 3 | 0.000000000 | 0.000000000 | | -1.00000000 | 131.930 |
| REFL | | | | | |
| 4 | 0.000000000 | -467.095641350 | | -1.00000000 | 90.070 |
| 5 | 199.893955036 | -10.268444544 | CAF2HL | -1.55840983 | 91.280 |
| 6 | 486.702942680AS | -26.734713685 | | -1.00000000 | 96.529 |
| 7 | 186.738998389 | -10.064297945 | CAF2HL | -1.55840983 | 99.240 |
| 8 | 447.975139348 | -19.001496621 | | -1.00000000 | 111.362 |
| 9 | 243.529966034 | 19.001496621 | | 1.00000000 | 114.369 |
| REFL | | | | | |
| 10 | 447.975139348 | 10.064297945 | CAF2HL | 1.55840983 | 112.384 |
| 11 | 186.738998389 | 26.734713685 | | 1.00000000 | 102.903 |
| 12 | 486.702942680AS | 10.268444544 | CAF2HL | 1.55840983 | 101.523 |
| 13 | 199.893955036 | 464.738613843 | | 1.00000000 | 96.499 |
| 14 | 0.000000000 | 0.000000000 | | -1.00000000 | 115.398 |
| REFL | | | | | |
| 15 | 0.000000000 | -100.235657635 | | -1.00000000 | 92.746 |
| 16 | -536.442986965 | -25.379215206 | CAF2HL | -1.55840983 | 94.306 |
| 17 | 629.049380815 | -7.436012624 | | -1.00000000 | 93.787 |
| 18 | 0.000000000 | -118.304806660 | | -1.00000000 | 91.342 |
| 19 | -312.177007433AS | -24.720749191 | CAF2HL | -1.55840983 | 94.928 |
| 20 | -734.696609024 | -220.443381712 | | -1.00000000 | 94.168 |
| 21 | -277.004238298AS | -15.426909916 | CAF2HL | -1.55840983 | 96.206 |
| 22 | -460.130899964 | -73.782961291 | | -1.00000000 | 95.245 |
| 23 | -158.318468619 | -30.586960517 | CAF2HL | -1.55840983 | 91.460 |
| 24 | -162.867000225 | -41.632945268 | | -1.00000000 | 84.793 |
| 25 | 419.508310212 | -20.539965049 | CAF2HL | -1.55840983 | 84.016 |
| 26 | -238.581080262 | -31.955227253 | | -1.00000000 | 85.006 |
| 27 | -430.197019246 | -30.182066783 | CAF2HL | -1.55840983 | 92.237 |
| 28 | 691.939037816AS | -23.703096035 | | -1.00000000 | 93.527 |
| 29 | -241.462660758AS | -10.000000000 | CAF2HL | -1.55840983 | 97.681 |
| 30 | -182.472613831 | -25.656103361 | | -1.00000000 | 96.159 |
| 31 | -420.041190250 | -36.705938298 | CAF2HL | -1.55840983 | 98.541 |
| 32 | 324.867666879 | -43.586137768 | | -1.00000000 | 99.096 |
| 33 | -44866.873107000 | 36.893151865 | | -1.00000000 | 93.979 |
| 34 | -149.830817441 | -28.311419778 | CAF2HL | -1.55840983 | 94.246 |
| 35 | -315.631878253AS | -18.939811826 | | -1.00000000 | 91.369 |
| 36 | -172.862510793 | -12.271843841 | CAF2HL | -1.55840983 | 87.996 |
| 37 | -115.635345524 | -27.567353538 | | -1.00000000 | 81.847 |
| 38 | -229.213645994AS | -32.436472831 | CAF2HL | -1.55840983 | 82.617 |
| 39 | 474.721571790 | -3.611495525 | | -1.00000000 | 81.971 |
| 40 | -152.435372054 | -30.802088433 | CAF2HL | -1.55840983 | 75.907 |
| 41 | -530.778945822 | -8.465514650 | | -1.00000000 | 70.966 |
| 42 | -159.504999222 | -41.060952888 | CAF2HL | -1.55840983 | 63.576 |
| 43 | 3040.455878600 | -4.225976128 | | -1.00000000 | 51.729 |
| 44 | -226.630329417AS | -24.123224774 | CAF2HL | -1.55840983 | 44.179 |
| 45 | 897.778633917 | -8.617797536 | | -1.00000000 | 33.827 |
| 46 | 0.000000000 | -8.000000000 | CAF2HL | -1.55840983 | 22.352 |
| 47 | 0.000000000 | -2.000000000 | IMMERS | -1.39000000 | 18.217 |
| 48 | 0.000000000 | 0.000000000 | | -1.00000000 | 17.067 |

14

**TABELLE 3 (Fortsetzung)**

ASPHAERISCHE KONSTANTEN

FLAECHE NR.   6

| | |
|---|---|
| K | 0.0000 |
| C1 | 3.87858881e-009 |
| C2 | -1.57703627e-013 |
| C3 | 1.62703226e-017 |
| C4 | -1.12332671e-021 |
| C5 | -1.51356191e-026 |
| C6 | 8.57130323e-031 |

FLAECHE NR.   12

| | |
|---|---|
| K | 0.0000 |
| C1 | 3.87858881e-009 |
| C2 | -1.57703627e-013 |
| C3 | 1.62703226e-017 |
| C4 | -1.12332671e-021 |
| C5 | -1.51356191e-026 |
| C6 | 8.57130323e-031 |

FLAECHE NR.   19

| | |
|---|---|
| K | 0.0000 |
| C1 | 3.62918557e-009 |
| C2 | 6.75596543e-014 |
| C3 | 5.68408321e-019 |
| C4 | -6.78832654e-023 |
| C5 | 6.78338885e-027 |
| C6 | -2.05303753e-031 |

FLAECHE NR.   21

| | |
|---|---|
| K | 0.0000 |
| C1 | 1.19759751e-008 |
| C2 | 7.35438590e-014 |
| C3 | 7.03292772e-019 |
| C4 | -1.26321026e-023 |
| C5 | -3.01047364e-027 |
| C6 | 2.08735313e-031 |

FLAECHE NR.   28

| | |
|---|---|
| K | 0.0000 |
| C1 | -8.39294529e-009 |
| C2 | -3.39607506e-013 |
| C3 | 8.76320979e-018 |
| C4 | -1.43578199e-021 |
| C5 | 5.59234999e-026 |
| C6 | 2.01810948e-030 |

FLAECHE NR.   29

| | |
|---|---|
| K | 0.0000 |
| C1 | 1.74092829e-008 |
| C2 | -1.69607632e-013 |
| C3 | 1.18281063e-017 |
| C4 | -3.08190938e-021 |
| C5 | 1.70082968e-025 |
| C6 | -1.68479126e-030 |

FLAECHE NR.   35

| | |
|---|---|
| K | 0.0000 |
| C1 | -2.14453018e-008 |
| C2 | 6.73947641e-013 |
| C3 | -4.84677574e-017 |
| C4 | 5.99264335e-021 |
| C5 | -2.87629386e-025 |
| C6 | 3.90592520e-031 |

FLAECHE NR.   38

| | |
|---|---|
| K | 0.0000 |
| C1 | 1.60415031e-008 |
| C2 | 4.78837509e-015 |
| C3 | 2.08320399e-016 |
| C4 | -2.87713700e-020 |
| C5 | 1.77485272e-024 |
| C6 | -1.93501550e-029 |

FLAECHE NR.   44

| | |
|---|---|
| K | 0.0000 |
| C1 | -6.56394686e-008 |
| C2 | -8.25210588e-012 |
| C3 | -1.27328625e-016 |
| C4 | -1.16616292e-020 |
| C5 | -1.58133131e-023 |
| C6 | 6.39526832e-027 |

TABELLE 4

j32o

| FLAECHE | RADIEN | DICKEN | GLAESER | BRECHZAHL 157.63 nm | 1/2 FREIER DURCHMESSER |
|---|---|---|---|---|---|
| 0 | 0.000000000 | 36.500665837 | | 1.00000000 | 85.333 |
| 1 | 304.292982078 | 22.168809366 | CAF2HL | 1.55840983 | 92.166 |
| 2 | 2741.794481050 | 96.128678854 | | 1.00000000 | 91.891 |
| 3 | 0.000000000 | 0.000000000 | | -1.00000000 | 131.415 |
| REFL | | | | | |
| 4 | 0.000000000 | -467.820384551 | | -1.00000000 | 89.765 |
| 5 | 199.893955036 | -10.268444544 | CAF2HL | -1.55840983 | 91.269 |
| 6 | 486.702942680AS | -26.059978075 | | -1.00000000 | 96.632 |
| 7 | 186.738998389 | -10.064297945 | CAF2HL | -1.55840983 | 99.260 |
| 8 | 447.975139348 | -19.256116633 | | -1.00000000 | 111.485 |
| 9 | 243.529966034 | 19.256116633 | | 1.00000000 | 114.609 |
| REFL | | | | | |
| 10 | 447.975139348 | 10.064297945 | CAF2HL | 1.55840983 | 112.551 |
| 11 | 186.738998389 | 26.059978075 | | 1.00000000 | 103.039 |
| 12 | 486.702942680AS | 10.268444544 | CAF2HL | 1.55840983 | 101.801 |
| 13 | 199.893955036 | 465.028501331 | | 1.00000000 | 96.752 |
| 14 | 0.000000000 | 0.000000000 | | -1.00000000 | 115.771 |
| REFL | | | | | |
| 15 | 0.000000000 | -100.235657635 | | -1.00000000 | 93.044 |
| 16 | -536.442986965 | -25.379215206 | CAF2HL | -1.55840983 | 94.574 |
| 17 | 629.049380815 | -8.746601911 | | -1.00000000 | 94.056 |
| 18 | 0.000000000 | -116.715874811 | | -1.00000000 | 91.368 |
| 19 | -312.177007433AS | -24.720749191 | CAF2HL | -1.55840983 | 94.620 |
| 20 | -734.696609024 | -220.365529295 | | -1.00000000 | 93.861 |
| 21 | -277.004238298AS | -15.426909916 | CAF2HL | -1.55840983 | 95.944 |
| 22 | -460.130899964 | -74.636127671 | | -1.00000000 | 94.984 |
| 23 | -158.318468619 | -30.586960517 | CAF2HL | -1.55840983 | 91.216 |
| 24 | -162.867000225 | -41.086604589 | | -1.00000000 | 84.569 |
| 25 | 419.508310212 | -20.539965049 | CAF2HL | -1.55840983 | 83.832 |
| 26 | -238.581080262 | -32.443299462 | | -1.00000000 | 84.836 |
| 27 | -430.197019246 | -30.182066783 | CAF2HL | -1.55840983 | 92.223 |
| 28 | 691.939037816AS | -22.851030925 | | -1.00000000 | 93.515 |
| 29 | -241.462660758AS | -10.000000000 | CAF2HL | -1.55840983 | 97.602 |
| 30 | -182.472613831 | -25.705407401 | | -1.00000000 | 96.085 |
| 31 | -420.041190250 | -36.705938298 | CAF2HL | -1.55840983 | 98.486 |
| 32 | 324.867666879 | -7.220642187 | | -1.00000000 | 99.044 |
| 33 | -149.830817441 | -28.311419778 | CAF2HL | -1.55840983 | 94.165 |
| 34 | -315.631878253AS | -11.206528270 | | -1.00000000 | 91.678 |
| 35 | 0.000000000 | -7.539660426 | | -1.00000000 | 92.142 |
| 36 | -172.862510793 | -12.271843841 | CAF2HL | -1.55840983 | 88.327 |
| 37 | -115.635345524 | -27.665363620 | | -1.00000000 | 82.122 |
| 38 | -229.213645994AS | -32.436472831 | CAF2HL | -1.55840983 | 82.891 |
| 39 | 474.721571790 | -3.783646156 | | -1.00000000 | 82.256 |
| 40 | -152.435372054 | -30.802088433 | CAF2HL | -1.55840983 | 76.122 |
| 41 | -530.778945822 | -8.330902516 | | -1.00000000 | 71.200 |
| 42 | -159.504999222 | -41.060952888 | CAF2HL | -1.55840983 | 63.821 |
| 43 | 3040.455878600 | -4.484154484 | | -1.00000000 | 51.982 |
| 44 | -226.630329417AS | -24.123224774 | CAF2HL | -1.55840983 | 44.183 |
| 45 | 897.778633917 | -0.971829936 | | -1.00000000 | 33.797 |
| 46 | 0.000000000 | -9.700651756 | CAF2HL | -1.55840983 | 31.743 |
| 47 | 0.000000000 | -7.828847134 | | -1.00000000 | 26.288 |
| 48 | 0.000000000 | 0.000446630 | | -1.00000000 | 17.067 |

EP 1 431 826 A2

TABELLE 4 (Fortsetzung)

ASPHAERISCHE KONSTANTEN

FLAECHE NR.   6

| | |
|---|---|
| K | 0.0000 |
| C1 | 3.87858881e-009 |
| C2 | -1.57703627e-013 |
| C3 | 1.62703226e-017 |
| C4 | -1.12332671e-021 |
| C5 | -1.51356191e-026 |
| C6 | 8.57130323e-031 |

FLAECHE NR.   12

| | |
|---|---|
| K | 0.0000 |
| C1 | 3.87858881e-009 |
| C2 | -1.57703627e-013 |
| C3 | 1.62703226e-017 |
| C4 | -1.12332671e-021 |
| C5 | -1.51356191e-026 |
| C6 | 8.57130323e-031 |

FLAECHE NR.   19

| | |
|---|---|
| K | 0.0000 |
| C1 | 3.62918557e-009 |
| C2 | 6.75596543e-014 |
| C3 | 5.68408321e-019 |
| C4 | -6.78832654e-023 |
| C5 | 6.78338885e-027 |
| C6 | -2.05303753e-031 |

FLAECHE NR.   21

| | |
|---|---|
| K | 0.0000 |
| C1 | 1.19759751e-008 |
| C2 | 7.35438590e-014 |
| C3 | 7.03292772e-019 |
| C4 | -1.26321026e-023 |
| C5 | -3.01047364e-027 |
| C6 | 2.08735313e-031 |

FLAECHE NR.   28

| | |
|---|---|
| K | 0.0000 |
| C1 | -8.39294529e-009 |
| C2 | -3.39607506e-013 |
| C3 | 8.76320979e-018 |
| C4 | -1.43578199e-021 |
| C5 | 5.59234999e-026 |
| C6 | 2.01810948e-030 |

FLAECHE NR.   29

| | |
|---|---|
| K | 0.0000 |
| C1 | 1.74092829e-008 |
| C2 | -1.69607632e-013 |
| C3 | 1.18281063e-017 |
| C4 | -3.08190938e-021 |
| C5 | 1.70082968e-025 |
| C6 | -1.68479126e-030 |

FLAECHE NR.   34

| | |
|---|---|
| K | 0.0000 |
| C1 | -2.14453018e-008 |
| C2 | 6.73947641e-013 |
| C3 | -4.84677574e-017 |
| C4 | 5.99264335e-021 |
| C5 | -2.87629386e-025 |
| C6 | 3.90592520e-031 |

FLAECHE NR.   38

| | |
|---|---|
| K | 0.0000 |
| C1 | 1.60415031e-008 |
| C2 | 4.78837509e-015 |
| C3 | 2.08320399e-016 |
| C4 | -2.87713700e-020 |
| C5 | 1.77485272e-024 |
| C6 | -1.93501550e-029 |

FLAECHE NR.   44

| | |
|---|---|
| K | 0.0000 |
| C1 | -6.56394686e-008 |
| C2 | -8.25210588e-012 |
| C3 | -1.27328625e-016 |
| C4 | -1.16616292e-020 |
| C5 | -1.58133131e-023 |
| C6 | 6.39526832e-027 |

17

TABELLE 5

j330

| FLAECHE | RADIEN | DICKEN | GLAESER | BRECHZAHL 157.63 nm | 1/2 FREIER DURCHMESSER |
|---|---|---|---|---|---|
| 0 | 0.000000000 | 38.054423655 | | 1.00000000 | 85.333 |
| 1 | 304.292982078 | 22.168809366 | CAF2HL | 1.55840983 | 92.441 |
| 2 | 2741.794481050 | 96.128678854 | | 1.00000000 | 92.171 |
| 3 | 0.000000000 | 0.000000000 | | -1.00000000 | 131.865 |
| REFL | | | | | |
| 4 | 0.000000000 | -467.749539716 | | -1.00000000 | 90.082 |
| 5 | 199.893955036 | -10.268444544 | CAF2HL | -1.55840983 | 91.444 |
| 6 | 486.702942680AS | -25.540971142 | | -1.00000000 | 96.627 |
| 7 | 186.738998389 | -10.064297945 | CAF2HL | -1.55840983 | 98.903 |
| 8 | 447.975139348 | -19.398954786 | | -1.00000000 | 110.873 |
| 9 | 243.529966034 | 19.398954786 | | 1.00000000 | 114.137 |
| REFL | | | | | |
| 10 | 447.975139348 | 10.064297945 | CAF2HL | 1.55840983 | 111.985 |
| 11 | 186.738998389 | 25.540971142 | | 1.00000000 | 102.576 |
| 12 | 486.702942680AS | 10.268444544 | CAF2HL | 1.55840983 | 101.403 |
| 13 | 199.893955036 | 465.154328539 | | 1.00000000 | 96.394 |
| 14 | 0.000000000 | 0.000000000 | | -1.00000000 | 115.447 |
| REFL | | | | | |
| 15 | 0.000000000 | -100.235657635 | | -1.00000000 | 92.750 |
| 16 | -536.442986965 | -25.379215206 | CAF2HL | -1.55840983 | 94.346 |
| 17 | 629.049380815 | -8.324209221 | | -1.00000000 | 93.829 |
| 18 | 0.000000000 | -117.663111488 | | -1.00000000 | 91.238 |
| 19 | -312.177007433AS | -24.720749191 | CAF2HL | -1.55840983 | 94.838 |
| 20 | -734.696609024 | -220.431435837 | | -1.00000000 | 94.085 |
| 21 | -277.004238298AS | -15.426909916 | CAF2HL | -1.55840983 | 96.283 |
| 22 | -460.130899964 | -74.271177440 | | -1.00000000 | 95.326 |
| 23 | -158.318468619 | -30.586960517 | CAF2HL | -1.55840983 | 91.580 |
| 24 | -162.867000225 | -41.410948173 | | -1.00000000 | 84.915 |
| 25 | 419.508310212 | -20.539965049 | CAF2HL | -1.55840983 | 84.171 |
| 26 | -238.581080262 | -32.165915708 | | -1.00000000 | 85.183 |
| 27 | -430.197019246 | -30.182066783 | CAF2HL | -1.55840983 | 92.511 |
| 28 | 691.939037816AS | -23.123455275 | | -1.00000000 | 93.802 |
| 29 | -241.462660758AS | -10.000000000 | CAF2HL | -1.55840983 | 97.962 |
| 30 | -182.472613831 | -25.738903727 | | -1.00000000 | 96.437 |
| 31 | -420.041190250 | -36.705938298 | CAF2HL | -1.55840983 | 98.835 |
| 32 | 324.867666879AS | -7.314163393 | | -1.00000000 | 99.389 |
| 33 | -149.830817441 | -28.311419778 | CAF2HL | -1.55840983 | 94.515 |
| 34 | -315.631878253AS | -15.768661491 | | -1.00000000 | 91.448 |
| 35 | 0.000000000 | -3.044279163 | | -1.00000000 | 91.163 |
| 36 | -172.862510793 | -12.271843841 | CAF2HL | -1.55840983 | 87.933 |
| 37 | -115.635345524 | -27.331297691 | | -1.00000000 | 81.792 |
| 38 | -229.213645994AS | -32.436472831 | CAF2HL | -1.55840983 | 82.538 |
| 39 | 474.721571790 | -4.085179748 | | -1.00000000 | 81.887 |
| 40 | -152.435372054 | -30.802088433 | CAF2HL | -1.55840983 | 75.743 |
| 41 | -530.778945822 | -8.090865960 | | -1.00000000 | 70.786 |
| 42 | -159.504999222 | -41.060952888 | CAF2HL | -1.55840983 | 63.559 |
| 43 | 3040.455878600 | -4.476231798 | | -1.00000000 | 51.715 |
| 44 | -226.630329417AS | -24.123224774 | CAF2HL | -1.55840983 | 44.004 |
| 45 | 897.778633917 | -0.971829936 | | -1.00000000 | 33.650 |
| 46 | 0.000000000 | -9.798128149 | CAF2HL | -1.55840983 | 31.626 |
| 47 | 0.000000000 | 0.000000000 | IMMERS | -1.39000000 | 26.153 |
| 48 | 0.000000000 | -7.818040520 | | -1.00000000 | 26.153 |
| 49 | 0.000000000 | 0.000266950 | | -1.00000000 | 17.067 |

TABELLE 5 (Fortsetzung)

**ASPHAERISCHE KONSTANTEN**

FLAECHE NR.    6                              FLAECHE NR.    29

K        0.0000                               K        0.0000
C1       3.87858881e-009                      C1       1.74092829e-008
C2      -1.57703627e-013                      C2      -1.69607632e-013
C3       1.62703226e-017                      C3       1.18281063e-017
C4      -1.12332671e-021                      C4      -3.08190938e-021
C5      -1.51356191e-026                      C5       1.70082968e-025
C6       8.57130323e-031                      C6      -1.68479126e-030

FLAECHE NR.    12                             FLAECHE NR.    32

K        0.0000                               K        0.0000
C1       3.87858881e-009                      C1      -3.60582630e-011
C2      -1.57703627e-013                      C2       2.95599027e-015
C3       1.62703226e-017                      C3      -7.37891981e-019
C4      -1.12332671e-021                      C4       6.32721261e-023
C5      -1.51356191e-026                      C5      -3.13935388e-027
C6       8.57130323e-031                      C6       0.00000000e+000

FLAECHE NR.    19                             FLAECHE NR.    34

K        0.0000                               K        0.0000
C1       3.62918557e-009                      C1      -2.14453018e-008
C2       6.75596543e-014                      C2       6.73947641e-013
C3       5.68408321e-019                      C3      -4.84677574e-017
C4      -6.78832654e-023                      C4       5.99264335e-021
C5       6.78338885e-027                      C5      -2.87629386e-025
C6      -2.05303753e-031                      C6       3.90592520e-031

FLAECHE NR.    21                             FLAECHE NR.    38

K        0.0000                               K        0.0000
C1       1.19759751e-008                      C1       1.60415031e-008
C2       7.35438590e-014                      C2       4.78837509e-015
C3       7.03292772e-019                      C3       2.08320399e-016
C4      -1.26321026e-023                      C4      -2.87713700e-020
C5      -3.01047364e-027                      C5       1.77485272e-024
C6       2.08735313e-031                      C6      -1.93501550e-029

FLAECHE NR.    28                             FLAECHE NR.    44

K        0.0000                               K        0.0000
C1      -8.39294529e-009                      C1      -6.56394686e-008
C2      -3.39607506e-013                      C2      -8.25210588e-012
C3       8.76320979e-018                      C3      -1.27328625e-016
C4      -1.43578199e-021                      C4      -1.16616292e-020
C5       5.59234999e-026                      C5      -1.58133131e-023
C6       2.01810948e-030                      C6       6.39526832e-027

TABELLE 6

j340

| FLAECHE | RADIEN | DICKEN | GLAESER | BRECHZAHL 157.63 nm | 1/2 FREIER DURCHMESSER |
|---|---|---|---|---|---|
| 0 | 0.000000000 | 36.161351461 | | 1.00000000 | 74.999 |
| 1 | 304.292982078 | 22.168809366 | CAF2HL | 1.55840983 | 80.904 |
| 2 | 2741.794481050 | 96.128678854 | | 1.00000000 | 80.670 |
| 3 | 0.000000000 | 0.000000000 | | -1.00000000 | 112.393 |
| REFL | | | | | |
| 4 | 0.000000000 | -467.829196611 | | -1.00000000 | 80.034 |
| 5 | 199.893955036 | -10.268444544 | CAF2HL | -1.55840983 | 91.463 |
| 6 | 486.702942680AS | -26.489029779 | | -1.00000000 | 96.705 |
| 7 | 186.738998389 | -10.064297945 | CAF2HL | -1.55840983 | 99.256 |
| 8 | 447.975139348 | -19.104022207 | | -1.00000000 | 111.038 |
| 9 | 243.529966034 | 19.104022207 | | 1.00000000 | 114.040 |
| REFL | | | | | |
| 10 | 447.975139348 | 10.064297945 | CAF2HL | 1.55840983 | 111.894 |
| 11 | 186.738998389 | 26.489029779 | | 1.00000000 | 102.220 |
| 12 | 486.702942680AS | 10.268444544 | CAF2HL | 1.55840983 | 100.696 |
| 13 | 199.893955036 | 464.947124417 | | 1.00000000 | 95.456 |
| 14 | 0.000000000 | 0.000000000 | | -1.00000000 | 100.079 |
| REFL | | | | | |
| 15 | 0.000000000 | -100.235657635 | | -1.00000000 | 82.389 |
| 16 | -536.442986965 | -25.379215206 | CAF2HL | -1.55840983 | 82.451 |
| 17 | 629.049380815 | -8.793894052 | | -1.00000000 | 81.752 |
| 18 | 0.000000000 | -116.568104874 | | -1.00000000 | 79.557 |
| 19 | -312.177007433AS | -24.720749191 | CAF2HL | -1.55840983 | 83.889 |
| 20 | -734.696609024 | -220.322326822 | | -1.00000000 | 83.299 |
| 21 | -277.004238298AS | -15.426909916 | CAF2HL | -1.55840983 | 89.258 |
| 22 | -460.130899964 | -74.392166007 | | -1.00000000 | 88.409 |
| 23 | -158.318468619 | -30.586960517 | CAF2HL | -1.55840983 | 86.736 |
| 24 | -162.867000225 | -41.203375310 | | -1.00000000 | 80.658 |
| 25 | 419.508310212 | -20.539965049 | CAF2HL | -1.55840983 | 79.998 |
| 26 | -238.581080262 | -32.439510521 | | -1.00000000 | 81.566 |
| 27 | -430.197019246 | -30.182066783 | CAF2HL | -1.55840983 | 89.557 |
| 28 | 691.939037816AS | -22.871775763 | | -1.00000000 | 91.095 |
| 29 | -241.462660758AS | -10.000000000 | CAF2HL | -1.55840983 | 95.940 |
| 30 | -182.472613831 | -25.719445559 | | -1.00000000 | 94.675 |
| 31 | -420.041190250 | -36.705938298 | CAF2HL | -1.55840983 | 97.416 |
| 32 | 324.867666879 | -7.158117532 | | -1.00000000 | 98.118 |
| 33 | -149.830817441 | -28.311419778 | CAF2HL | -1.55840983 | 94.383 |
| 34 | -315.631878253AS | -15.246525268 | | -1.00000000 | 91.407 |
| 35 | 0.000000000 | -3.460262414 | | -1.00000000 | 91.263 |
| 36 | -172.862510793 | -12.271843841 | CAF2HL | -1.55840983 | 87.558 |
| 37 | -115.635345524 | -27.669597804 | | -1.00000000 | 81.275 |
| 38 | -229.213645994AS | -32.436472831 | CAF2HL | -1.55840983 | 81.851 |
| 39 | 474.721571790 | -3.859943832 | | -1.00000000 | 81.002 |
| 40 | -152.435372054 | -30.802088433 | CAF2HL | -1.55840983 | 74.327 |
| 41 | -530.778945822 | -8.295933466 | | -1.00000000 | 68.995 |
| 42 | -159.504999222 | -41.060952888 | CAF2HL | -1.55840983 | 61.568 |
| 43 | 3040.455878600 | -4.464476855 | | -1.00000000 | 49.097 |
| 44 | -226.630329417AS | -24.123224774 | CAF2HL | -1.55840983 | 41.663 |
| 45 | 897.778633917 | -0.971829936 | | -1.00000000 | 30.986 |
| 46 | 0.000000000 | -9.748905783 | CAF2HL | -1.55840983 | 29.101 |
| 47 | 0.000000000 | 0.000000000 | IMMERS | -1.39000000 | 23.730 |
| 48 | 0.000000000 | -7.827028317 | | -1.00000000 | 23.730 |
| 49 | 0.000000000 | 0.000419580 | | -1.00000000 | 15.000 |

TABELLE 6 (Fortsetzung)


ASPHAERISCHE KONSTANTEN

FLAECHE NR.   6

K        0.0000
C1       3.87858881e-009
C2      -1.57703627e-013
C3       1.62703226e-017
C4      -1.12332671e-021
C5      -1.51356191e-026
C6       8.57130323e-031

FLAECHE NR.   12

K        0.0000
C1       3.87858881e-009
C2      -1.57703627e-013
C3       1.62703226e-017
C4      -1.12332671e-021
C5      -1.51356191e-026
C6       8.57130323e-031

FLAECHE NR.   19

K        0.0000
C1       3.62918557e-009
C2       6.75596543e-014
C3       5.68408321e-019
C4      -6.78832654e-023
C5       6.78338885e-027
C6      -2.05303753e-031

FLAECHE NR.   21

K        0.0000
C1       1.19759751e-008
C2       7.35438590e-014
C3       7.03292772e-019
C4      -1.26321026e-023
C5      -3.01047364e-027
C6       2.08735313e-031

FLAECHE NR.   28

K        0.0000
C1      -8.39294529e-009
C2      -3.39607506e-013
C3       8.76320979e-018
C4      -1.43578199e-021
C5       5.59234999e-026
C6       2.01810948e-030

FLAECHE NR.   29

K        0.0000
C1       1.74092829e-008
C2      -1.69607632e-013
C3       1.18281063e-017
C4      -3.08190938e-021
C5       1.70082968e-025
C6      -1.68479126e-030

FLAECHE NR.   34

K        0.0000
C1      -2.14453018e-008
C2       6.73947641e-013
C3      -4.84677574e-017
C4       5.99264335e-021
C5      -2.87629386e-025
C6       3.90592520e-031

FLAECHE NR.   38

K        0.0000
C1       1.60415031e-008
C2       4.78837509e-015
C3       2.08320399e-016
C4      -2.87713700e-020
C5       1.77485272e-024
C6      -1.93501550e-029

FLAECHE NR.   44

K        0.0000
C1      -6.56394686e-008
C2      -8.25210588e-012
C3      -1.27328625e-016
C4      -1.16616292e-020
C5      -1.58133131e-023
C6       6.39526832e-027

**EP 1 431 826 A2**

**Patentansprüche**

1. Projektionsobjektiv zur Abbildung eines in einer Objektebene des Projektionsobjektivs angeordneten Musters in eine Bildebene des Projektionsobjektivs mit einer Vielzahl von optischen Elementen, die entlang einer optischen Achse des Projektionsobjektivs angeordnet sind, wobei:
   die optischen Elemente eine der Objektebene folgende erste Gruppe von optischen Elementen und ein der ersten Gruppe folgendes, der Bildebene nächstes letztes optisches Element umfassen, das eine Austrittsfläche des Projektionsobjektivs definiert, die in einem Arbeitsabstand zur Bildebene angeordnet ist;
   das letzte optische Element im Wesentlichen brechkraftfrei ist und keine oder nur eine geringe Durchbiegung hat; und
   das Projektionsobjektiv bezüglich Aberrationen darauf abgestimmt ist, dass der Arbeitsabstand mit einem Immersionsmedium mit einem Brechungsindex deutlich größer als 1 ausgefüllt ist.

2. Projektionsobjektiv nach Anspruch 1, bei dem zwischen der ersten Gruppe und dem letzten optischen Element ein großer Abstand besteht, der eine substantielle axiale Verlagerung des letzten optischen Elementes ermöglicht, wobei vorzugsweise ein freier Abstand vor dem letzten Element mehr als ca. 0,5% der Baulänge des Projektionsobjektivs beträgt und/oder wobei eine Summe aus dem freien Abstand vor dem letzten optischen Element und dem Abstand zwischen Austrittsfläche und Bildebene größer ist als ca. 0,5% der Baulänge des Projektionsobjektivs.

3. Projektionsobjektiv nach einem der vorhergehenden Ansprüche, das mit Hilfe einer Veränderung der Dicke des letzten optischen Elementes, vorzugsweise in Verbindung mit einer Verlagerung des letzten optischen Elementes relativ zur Bildebene, zwischen einer Immersionskonfiguration und einer Trockenkonfiguration weitgehend oder vollständig abstimmbar ist.

4. Projektionsobjektiv nach einem der vorhergehenden Ansprüche, bei dem das letzte optische Element zwischen verschiedenen Axialpositionen der optischen Achse verlagerbar ist, wobei das letzte optische Element vorzugsweise entlang der optischen Achse verschiebbar ist.

5. Projektionsobjektiv nach einem der vorhergehenden Ansprüche, bei dem das letzte optische Element auswechselbar ist.

6. Projektionsobjektiv nach einem der vorhergehenden Ansprüche, bei dem das letzte optische Element eine veränderbare Dicke hat, wobei das letzte optische Element vorzugsweise eine Dicke hat, die ohne Materialabtrag oder Materialauftrag veränderbar ist.

7. Projektionsobjektiv nach Anspruch 6, bei dem das letzte optische Element mehrere voneinander lösbare Komponenten umfasst, die mit Abstand zueinander angeordnet oder optisch neutral miteinander verbunden sind, wobei vorzugsweise Komponenten des letzten optischen Elementes aus unterschiedlichen optischen Materialien bestehen, wobei vorzugsweise mindestens eine Komponente aus Fluoridkristall, insbesondere aus Lithiumfluorid oder Kalziumfluorid besteht.

8. Projektionsobjektiv nach einem der vorhergehenden Ansprüche, bei dem das letzte optische Element mindestens eine im wesentlichen planparallele Platte aus transparentem Material umfasst, wobei es vorzugsweise durch eine einzelne planparallele Platte gebildet ist, oder zwei voneinander trennbare, im wesentlichen planparallele Platten aus transparentem Material umfasst.

9. Projektionsobjektiv nach einem der vorhergehenden Ansprüche, bei dem das letzte optische Element eine ebene Austrittsfläche hat.

10. Projektionsobjektiv nach einem der vorhergehenden Ansprüche, bei dem das an die Austrittsfläche angrenzende optische Material des letzten optischen Elements einen Brechungsindex $n_E$ hat, der in der Nähe des Brechungsindex n, des Immersionsmediums liegt, wobei vorzugsweise ein Verhältnis $n_I / n_E$ mehr als 0,8, insbesondere mehr als 0,9 beträgt.

11. Projektionsobjektiv nach einem der vorhergehenden Ansprüche, bei dem die optischen Elemente der ersten Gruppe mindestens ein verlagerbares optisches Element umfassen, wobei vorzugsweise mehrere, insbesondere mindestens fünf verlagerbare optische Elemente vorgesehen sind und/oder wobei mindestens eines der verlagerbaren

22

optischen Elemente entlang der optischen Achse verschiebbar ist.

**12.** Projektionsobjektiv nach Anspruch 11, bei dem ein freier Abstand vor dem verlagerbaren Element und/oder hinter dem verlagerbaren Element so groß bemessen ist, dass durch Verlagerung des mindestens einen verlagerbaren optischen Elementes mindestens ein Anteil von Aberrationen korrigierbar ist, die durch Anpassung des letzten optischen Elementes an ein Immersionsmedium entstehen.

**13.** Projektionsobjektiv nach einem der vorhergehenden Ansprüche, dem mindestens ein auswechselbares optisches Korrekturelement zugeordnet ist, das vorzugsweise mindestens eine asphärsche Fläche aufweist.

**14.** Projektionsobjektiv nach einem der vorhergehenden Ansprüche, dem mindestens ein optisches Element der ersten Gruppe mindestens eine optische Fläche mit einer reversibel oder permanent veränderbaren Flächenkrümmung hat.

**15.** Projektionsobjektiv nach einem der vorherigen Ansprüche, welches bei Verwendung eines Immersionsmediums zwischen Austrittsfläche und Bildebene eine bildseitige numerische Apertur (NA) NA < 1 hat, wobei die bildseitige numerische Apertur vorzugsweise zwischen ca. 0,7 und 1, insbesondere zwischen 0,8 und 1 liegt.

**16.** Projektionsobjektiv nach einem der vorherigen Ansprüche, bei dem das letzte optische Element aus dem Projektionsobjektiv entfernbar und durch eine im Vergleich zur Austrittsfläche des Projektionsobjektives grosse Planparalellplatte ersetzbar ist, die auf ein zu belichtendes Objekt grossflächig auflegbar ist.

**17.** Projektionsobjektiv zur Abbildung eines in einer Objektebene des Projektionsobjektivs angeordneten Musters in eine Bildebene des Projektionsobjektivs mit einer Vielzahl von optischen Elementen, die entlang einer optischen Achse des Projektionsobjektivs angeordnet sind, wobei:
die optischen Elemente eine der Objektebene folgende erste Gruppe von optischen Elementen und ein der ersten Gruppe folgendes, der Bildebene nächstes letztes optisches Element umfassen, das eine Austrittsfläche des Projektionsobjektivs definiert, die in einem Arbeitsabstand zur Bildebene angeordnet ist;
das letzte optische Element im Wesentlichen brechkraftfrei ist und keine oder nur eine geringe Durchbiegung hat; und
das Projektionsobjektiv bezüglich Aberrationen darauf abgestimmt ist, dass der Arbeitsabstand mit einem Gas mit einem Brechungsindex nahe 1 ausgefüllt ist.

**18.** Projektionsobjektiv nach Anspruch 17, **gekennzeichnet durch** die Merkmale des kennzeichnenden Teils von mindestens einem der Ansprüche 2 bis 14.

**19.** Projektionsobjektiv nach einem der vorherigen Ansprüche, das ein rein dioprisches (refraktives) Projektionsobjektiv ist, oder das ein katadioptrisches Projektionsobjektiv ist, insbesondere mit mindestens einem reellen Zwischenbild, wobei das katadioptrische Projektionsobjektiv vorzugsweise einen physikalischen Strahlteiler oder geometrischen Strahlteiler umfasst

**20.** Verfahren zur Abstimmung eines Projektionsobjektivs, das zur Abbildung eines in einer Objektebene des Projektionsobjektivs angeordneten Musters in eine Bildebene des Projektionsobjektivs vorgesehen ist und eine Vielzahl von optischen Elementen aufweist, wobei die optischen Elemente eine der Objektebene folgende erste Gruppe von optischen Elementen und ein der ersten Gruppe folgendes, der Bildebene nächstes letztes optisches Element umfassen, das eine Austrittsfläche des Projektionsobjektivs definiert, die in einem Arbeitsabstand zur Bildebene angeordnet ist; das letzte optische Element im Wesentlichen brechkraftfrei ist und keine oder nur eine geringe Durchbiegung hat, wobei das Verfahren folgende Schritte umfasst:

Veränderung der Dicke des letzten optischen Elementes; und
Änderung des Brechungsindex des Raumes zwischen der Austrittsfläche und der Bildebene durch Einführen oder Entfernen eines Immersionsmediums.

**21.** Verfahren nach Anspruch 20, bei dem eine axiale Verlagerung des letzten optischen Elementes zur Einstellung eines geeigneten Arbeitsabstandes durchgeführt wird.

**22.** Verfahren nach Anspruch 20 oder 21, bei dem für einen Übergang von einer Immersionskonfiguration zu einer Trockenkonfiguration der Brechungsindex im Bildraum von relativ hohen Werten eines Immersionsmediums auf kleinere Werte für ein geeignetes Gas verringert, die Dicke des letzten optischen Elementes vergrößert und vorzugsweise das optische Element in Richtung der ersten Gruppe verlagert wird, um einen größeren Arbeitsabstand einzustellen.

**23.** Verfahren nach Anspruch 20 oder 21, bei dem für einen Übergang von einer Trockenkonfiguration zu einer Immersionskonfiguration der Brechungsindex im Bildraum von relativ niedrigen Werten für ein geeignetes Gas auf größere Werte eines Immersionsmediums vergrößert, die Dicke des letzten optischen Elementes verringert und vorzugsweise das letzte optische Element in Richtung der Bildebene verlagert wird, um einen kleineren Arbeitsabstand einzustellen.

**24.** Verfahren nach einem der Ansprüche 20 bis 23, bei dem zur Veränderung der Dicke des letzten optischen Elementes und/oder zur axialen Verlagerung des letzten optischen Elementes ein Austausch eines letzten optischen Elementes gegen ein anderes letztes optisches Element mit anderer Dicke und/oder anderer Axialposition vorgenommen wird.

**25.** Verfahren nach einem der Ansprüche 20 bis 25, **gekennzeichnet durch** eine Verwendung eines letzten optischen Elementes, das mehrere voneinander lösbare Komponenten, insbesondere planparallele Platten, umfasst, die mit Abstand zueinander angeordnet oder optisch neutral miteinander verbunden sind, wobei die Veränderung der Dicke des letzten optischen Elementes ein Hinzufügen einer Komponente zur Vergrößerung der Dicke oder eine Wegnahme einer Komponente zur Verkleinerung der Dicke umfasst.

**26.** Verfahren nach einem der Ansprüche 20 bis 26, **gekennzeichnet durch** eine Veränderung des Korrektionszustandes der ersten Gruppe zur Verringerung von Restaberrationen des Projektionsobjektivs, wobei vorzugsweise zur Veränderung des Korrektionszustandes der ersten Gruppe mindestens ein optisches Element der ersten Gruppe verlagert, insbesondere axial verschoben wird, und/oder wobei zur Veränderung des Korrektionszustandes der ersten Gruppe mindestens eine Korrekturfläche eingefügt oder an einer optischen Fläche erzeugt wird, und/oder wobei zur Veränderung des Korrektionszustandes der ersten Gruppe an mindestens einem optischen Element der ersten Gruppe mindestens eine Flächenkrümmung reversibel oder permanent verändert wird, und/oder wobei zur Veränderung des Korrektionszustandes des Projektionsobjektives dessen numerische Apertur und/oder seine Feldgröße verändert wird.

**27.** Verfahren zur Abstimmung eines Projektionsobjektiv, das zur Abbildung eines in einer Objektebene des Projektionsobjektivs angeordneten Musters in eine Bildebene des Projektionsobjektivs vorgesehen ist und eine Vielzahl von optischen Elementen aufweist, wobei die optischen Elemente eine der Objektebene folgende erste Gruppe von optischen Elementen und ein der ersten Gruppe folgendes, der Bildebene nächstes letztes optisches Element umfassen, das eine Austrittsfläche des Projektionsobjektivs definiert, die in einem Arbeitsabstand zur Bildebene angeordnet ist; und das letzte optische Element im Wesentlichen brechkraftfrei ist und keine oder nur eine geringe Durchbiegung hat, wobei das Verfahren folgende Schritte umfasst:

Entfernen des letzten optischen Elements aus dem Projektionsobjektiv zur Erzeugung eines Rest-Objektivs;
Ersetzen des letzten optischen Elementes durch eine im Vergleich zur Austrittsfläche des Projektionsobjektives grosse Planparalellplatte;
Aufbringen einer Schicht eines Immersionsmediums auf einen zu belichtenden Gegenstand
Auflegen der Planparallelplatte auf die Schicht eines Immersionsmediums;
Belichten des zu belichtenden Gegenstandes durch diese Platten-Immersionskombination hindurch mit Hilfe des Rest-Objektivs.

**28.** Verfahren nach Anspruch 27, **gekennzeichnet durch** mindestens eines der Merkmale des kennzeichnenden Teils von Anspruch 26.

**29.** Verfahren zur Abstimmung eines Projektionsobjektiv, das zur Abbildung eines in einer Objektebene des Projektionsobjektivs angeordneten Musters in eine Bildebene des Projektionsobjektivs vorgesehen ist und eine Vielzahl von optischen Elementen aufweist, wobei die optischen Elemente eine der Objektebene folgende erste Gruppe von optischen Elementen und ein der ersten Gruppe folgendes, der Bildebene nächstes letztes optisches Element umfassen, das eine Austrittsfläche des Projektionsobjektivs definiert, die in einem Arbeitsabstand zur Bildebene angeordnet ist; wobei das Verfahren folgende Schritte umfasst:

Abspalten einer planparallelen Platte von dem letzten optischen Element zur Vermindeung der Dicke;

Vergrößerung des Brechungsindex des Raumes zwischen der Austrittsfläche und der Bildebene durch Einführen oder Entfernen eines Immersionsmediums.

Fig. 1

Fig. 2

11

13

10

14

19

15

17   12   16   18

(a)

(b)

(c)

11

13

14

10

19

15

17   12   16

(a)

(b)

(c)

EP 1 431 826 A2

Fig. 3

Fig. 4

Fig. 5

_Fig._ 6

34

35 38

32

30

_Fig._ 7

34

35'

32

37

EP 1 431 826 A2

Fig 10

Fig 9

Fig. 8